# EUROPEAN PATENT APPLICATION

(11) **EP 2 579 695 A1**
(43) Date of publication of application: **10.04.2013**
(21) Application number: 11789939.3
(22) Date of filing: 03.06.2011
(51) Int. Cl.: H05K 3/18, H01P 11/00, H01Q 1/24, H01Q 1/38, H01Q 9/42, H01Q 13/08, H04B 1/18, H05K 3/00, H05K 3/14

(54) **PRINTED CIRCUIT BOARD, ANTENNA, WIRELESS COMMUNICATION DEVICE AND MANUFACTURING METHODS THEREOF**

(30) Priority: 24.01.2011 JP 2011012405; 09.07.2010 JP 2010156301; 29.06.2010 JP 2010147151; 04.06.2010 JP 2010129339
(71) Applicant: Furukawa Electric Co., Ltd., Chiyoda-ku Tokyo 100-8322 (JP)
(72) Inventor: HAMADA, Hiroki, Tokyo 100-8322 (JP); TAMAOKA, Hiroyuki, Tokyo 100-8322 (JP); ISO, Yoichi, Tokyo 100-8322 (JP)
(74) Representative: advotec.
(86) International application number: PCT/JP2011/062850
(87) International publication number: WO 2011/152538

(57) **Abstract**

Low-loss printed circuit boards, low-loss wide-band antennas, and manufacturing methods thereof are provided by using a resin as a boardmaterial. Aresinmaterial (101) having a predetermined shape is prepared in a molding step, and the resin material (101) is foamed in a foaming step. As a result, a skin layer (111) and a foamed part (112) are formed. Since the skin layer (111) does not allow close contact of plating, the skin layer (111) is removed in the shape of a conductor pattern in a skin-layer removing step to expose the foamed part (112) in the interior. Electroless plating is carried out in a conductor-layer forming step; and, as a result, plating is brought into close contact with the foamed part (112) having an anchor effect, and a conductor layer (120) is formed.

## Description

### Technical Field

The present invention relates to printed circuit boards, antennas, wireless communication devices, and manufacturing methods thereof using a resin as a board material and particularly relates to printed circuit boards, antennas, and wireless communication devices formed to have low-dielectric constants by causing the interior of the resin to have a foamed structure and to manufacturing methods thereof.

### Background Art

As manufacturing methods of printed circuit boards using a resin as a board and forming a conductor pattern thereon, a two-color molding method and an insert molding method have been conventionally known. In the two-color molding method, for example, as described in Patent Literature 1, a shape corresponding to a conductor pattern is injection-molded with a first resin to which metal easily adheres, and a shape of a part other than a circuit pattern of the first resin is injection-molded with a second resin to which metal does not easily adhere. Then, the surface on which the conductor pattern of the first resin is formed is activated by roughening by etching, catalyst application, catalyst activation, etc., and electroless plating is carried out, thereby forming the conductor pattern. In Patent Literature 1, ABS (acrylonitrile butadiene styrene) is used as the first resin to which metal easily adheres, and PC (polycarbonate) is used as the second resin to which metal does not easily adhere.

In the two-color molding method, the degree of freedom in the shape of a circuit board and the degree of freedom of the wiring of a conductor pattern are high; however, two molds are required, and cost is high. Cost is also taken since molding is carried out twice. Moreover, in order to support design change, the molds have to be changed, and supportability with respect to design change is low.

In the insert molding, a printed circuit board is manufactured by disposing a circuit pattern, which has been formed by pressing a sheet metal, in a mold and injecting a resin into the mold (for example, Patent Literature 2). In the insert molding, the shape of the circuit board and wiring of a conductor pattern are somewhat limited, and the degree of freedom is lowered. Moreover, since two molds, i.e., the mold and a pressing mold are required, cost is high, and supportability with respect to design change is also low since the molds have to be changed.

As further another manufacturing method of a printed circuit board using a resin, there is a LDS (Laser Direct Structuring) method. In the LDS method, LCD (liquid crystal polymer), PBT (polybutylene terephthalate), or the like serves as a base polymer, a mixture of it and a filler organic metal is molded into a predetermined shape, it is irradiated with laser in a predetermined circuit pattern shape, and plating is deposited only on the laser irradiation part to form a circuit.

Generally, in an antenna device mounted on, for example, a mobile terminal or a car; a control board, an antenna, etc. are housed in a case consisting of a front side case part and a back side case part. For example, in a mobile terminal, a control board, etc. are mounted on an inner surface of the front side case part, while an antenna is mounted on an inner surface of the back side case part in many cases; and, when the front side case part and the back side case part are mated with each other, the control board, etc. and the antenna are configured to be electrically connected.
(For example, Patent Literature 3). Examples of conventional antenna devices are shown in Figures 21 and 22.

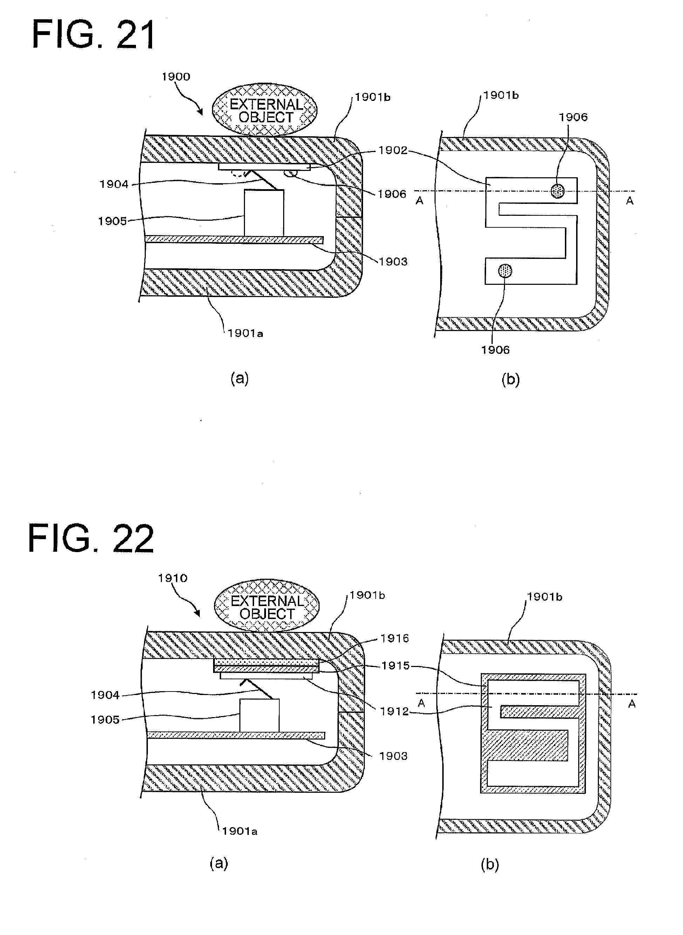

An antenna device 1900 shown in Figure 21 shows a configuration of a mobile terminal as an example, wherein an antenna pattern 1902 is attached to the inner surface of a back side case part 1901b, and a control board 1903 is attached to the inner surface of a front side case part 1901a. Figure 21 (a) shows a cross-sectional view enlarging the vicinity of the antenna pattern 1902 of the antenna device 1900, and Figure 21 (b) shows a plan view enlarging the vicinity of the antenna pattern 1902 on the inner surface of the back side case part 1901b. The antenna pattern 1902 is formed of a sheet metal composed of, for example, SUS or phosphor bronze having a thickness of about 0.1 to 0.2 mm and is welded on the inner surface of the back side case part 1901b by welding bosses 1906 made of a resin. A feed terminal 1904 held by a terminal holding part 1905 is placed on the control board 1903. When the front side case part 1901a and the back side case 1901b are mated with each other, the antenna pattern 1902 is configured to be electrically connected to the control board 1903 by the feed terminal 1904.

In an antenna device 1910 shown in Figure 22, FPC (Flexible Printed Circuit) 1915 composed of PI (polyimide) or PET having a thickness of about 12.5 to 50 µm serves as a base film, and an antenna pattern 1912 is formed thereon. When the FPC 1915 is caused to adhere to the inner surface of the back side case part 1901b by a double-sided tape 1916 having a thickness of about 50 µm, the antenna pattern 1912 is fixed to the back side case part 1901b side. When the front side case part 1901a and the back side case part 1901b are mated with each other, the antenna pattern 1912 is electrically connected to the control board 1903 by the feed terminal 1904.

Along with increase in the capacity of wireless communication, the needs for developing antenna devices capable of obtaining highly-efficient wide-band characteristics are increasing. As an antenna device, a microstrip antenna as described in Patent Literature 4 has been conventionally known. In the microstrip antenna, generally, an antenna pattern and a feed line are formed on the same plane of a board, and a ground is formed on the other surface thereof. Conventionally, resins having comparatively high dielectric constants have been used in antenna boards.

In an antenna device, generally, when the dielectric constant of an antenna board is reduced and the thickness of the board is increased, dielectric loss (tan δ) can be reduced to achieve high efficiency, and wide-band characteristics can be obtained. On the other hand, in order to downsize the antenna, the dielectric constant of the board is preferred to be high. Therefore, in an antenna device of which antenna pattern is not required to be downsized and which has, for example, a used frequency of 5 GHz band or more (wavelength is 6 cm or less), a board having a low dielectric constant can be used as an antenna board on which an antenna pattern is formed, and, as a result, highly-efficient and wide-band characteristics can be obtained. Particularly, in a microstrip patch antenna, in which a patch antenna is formed on a dielectric board, it is preferred that the dielectric constant of the board is low and the thickness of the board is thick.

Recently, demands for smartphones, which are mobile phones provided with high-functional information terminal functions, have been increasing. The smartphones require utilization of large-capacity wireless data communication compared with conventional mobile terminals. Utilization of wireless communication is increasing also in personal computers (PC), and large-capacity wireless data communication is also required. In order to support such needs, communication standards such as WLAN (IEEE802.11n), WiMax, and LTE have been sequentially introduced. Under such circumstances, a technique called MIMO (Multiple-Input Multiple-Output) that carries out communication by using a plurality of antennas with respect to at least the same receiving frequency band is important as one of major techniques for improving communication quality and transmission capacity.

In order to apply the MIMO technique, it is important to maintain the correlations among the antennas to be low (maintain correlation coefficients to be small) so that the plurality of antennas respectively receive different signals of the same frequency band. Generally, the correlation coefficients can be reduced by sufficiently increasing the distances between the antennas.

When a plurality of antennas are to be mounted on each of various information communication terminals typified by smartphones, input/output parts for connecting the plurality of antennas to a circuit part, which processes high-frequency signals, are provided in a predetermined region so as to be close to each other. Therefore, when the distances between the antennas are to be sufficiently increased, the distances between at least part of the antennas and the input/output part have to be increased, and some sort of transmission lines for connecting the part therebetween are required.

Techniques about transmission lines that connect antennas and an input/output part of a high-frequency circuit part are disclosed in Patent Literatures 5 to 7. In Patent Literature 5, as shown in Figure 37 (a), an antenna 3900 and a main circuit board 3901 are disposed to be spaced away from each other, and a coaxial cable 3902 is used as a transmission line connecting the part therebetween.

In Patent Literature 6, as shown in Figure 37 (b), a bulging wall 3913 of a dielectric material projecting toward outside from a dielectric base 3912, on which a feeded radiation electrode 3911 is formed, is disposed on the surface of a ground part 3914; and a transmission line 3917 having a set line length connecting a feed side end part 3915 of the feeded radiation electrode 3911 and an input/output part 3916 of a circuit is formed on the bulging wall 3913. The transmission line 3917 serves as a phase adjusting means which adjusts the phase of the electric power feeded from a wireless communication circuit to the feeded radiation electrode 3911. It is described that the transmission line 3917 is configured to be a microstrip line.

Furthermore, as shown in Figure 37 (c), Patent Literature 7 discloses a planar antenna unit 3920 forming, by a means such as etching, a radiation electrode 3921 and a ground electrode 3924 insulated from the radiation electrode 3921 on a first-side principal surface of an insulator sheet 3923 and a transmission line 3922 on a second-side principal surface. At an end part of the transmission line 3922 in the side opposite to the radiation electrode 3921, a transmission-line connecting part 3926 and ground-electrode connecting parts 3925 and 3927 for connecting connector terminals are formed by soldering.

### Citation List

### Patent Literatures

Patent Literature 1: Japanese Patent Application Laid-Open No. 2007-208859
Patent Literature 2: Japanese Patent Application Laid-Open No. 2007-89109
Patent Literature 3: Japanese Patent Application Laid-Open No. 2007-267003
Patent Literature 4: Japanese Patent Application Laid-Open No. 2000-101341
Patent Literature 5: US7492321
Patent Literature 6: Japanese Patent Application Laid-Open No. 2007-306507
Patent Literature 7: Japanese Patent Application Laid-Open No. H10-75115

### Summary of Invention

### Technical Problems

However, in the above described conventional manufacturing methods of printed circuit boards and the printed circuit boards and antennas manufactured by using them have below problems. In order to further improve antenna characteristics and widen a band, the dielectric constant of a board has to be further reduced (for example, to 2 or less in specific inductive capacity); however, a conventional circuit board using a resin has been often selected depending on, for example, platability or formability, and it has been difficult to further reduce the dielectric constant. Particularly, in a LDS method, a special resin containing a metal as filler is used; therefore, cost becomes high, and, in addition to that, there are problems that dielectric tangent (tan δ) is deteriorated and dielectric loss is increased.

Moreover, the above described conventional antenna devices and the manufacturing methods thereof have below problems. In order to realize a highly-efficient antenna device, the dielectric loss of an antenna has to be reduced, and a low-dielectric-constant antenna board has to be used for that; however, conventionally, it has been difficult to reduce the dielectric constant of the antenna board.

The antenna pattern is disposed on or in the vicinity of the back side case part. Therefore, if an external obj ect composed of a metal or a high-dielectric body is present near the outer part of the back side case part, there is a problem that antenna characteristics are strongly affected by that and deteriorated. In order to reduce the influence exerted on the antenna pattern from the objects there a round and obtain good antenna characteristics, it is desired that the distance between the antenna pattern 922 and the object therearound be increased as much as possible. More specifically, when the distance D2 from the antenna pattern 922 shown in Figure 23 to an outer surface of the back side case part 921b is increased, the influence on the antenna characteristics of, for example, a case in which a hand (external object) contacts the back side case part 921b can be reduced. Similarly, the antenna characteristics can be improved by increasing the distance D1 from the antenna pattern 922 to a ground 923a on a control board 923.

However, conventionally, there have been strong needs for downsizing of antenna devices; therefore, increasing the distance D1 or D2 is against such needs. Particularly, if the antenna device is a mobile terminal, it is normally held by a hand and used; therefore, reducing the influence of the external object, which is exerted on the antenna device, as much as possible is strongly desired.

The above described conventional antenna devices also have below problems. In a conventional microstrip antenna in which an antenna pattern and a feed line are formed on the same plane like the microstrip antenna described in Patent Literature 5, there has been a problem that, if the thickness of a board is increased in order to obtain highly-efficient wide-band antenna characteristics, unnecessary radiation at the feed line is increased, and loss is increased.

However, if a coaxial cable is used as a transmission line like Patent Literature 5, low-loss signal transmission can be carried out; however, the cost of the coaxial cable is high, and, in addition to that, there are problems that the number of parts of connectors, matching circuits, etc. is increased, and cost becomes high. The transmission line described in Patent Literature 6 is for adjusting impedance of an antenna and has a short distance, and it is difficult to carry out transmission at low loss in a comparatively long distance between the antenna andtheinput/output part of the high-frequency circuit.

Furthermore, in Patent Literature 7, the transmission line is combined with the ground electrode to form the microstrip line, and a connector is connected at a comparatively short distance from the radiation electrode. It is also conceivable to increase the length of the insulator sheet and the transmission line; however, in the configuration in which the ground electrode is connected to a main ground plate of small high-frequency equipment only by the ground electrode connecting part provided at the one end of the insulator sheet, it is difficult to reduce the loss in the transmission line having an increased length.

The present invention has been accomplished to solve these problems, and it is an object to provide a low-loss printed circuit board, a low-loss and wide-band antenna, and manufacturing methods thereof by using a resin as a board material.

It is also an object to provide an antenna device which has low dielectric loss and has reduced influence from external objects and to provide manufacturing methods thereof.

It is also an object to provide an antenna device using a foamed dielectric resin, which is capable of obtaining low-loss and wide-band characteristics, in an antenna board.

It is further another object to provide a wireless communication device provided with a low-cost transmission line capable of carrying out signal transmission at low loss between an antenna and a high-frequency circuit part.

### Solutions to Problems

A first aspect of a manufacturing method of a printed circuit board of the present invention has: a foaming step of forming a foamed part having a foamed structure in at least part of its interior by subjecting a predetermined resin to a foaming process and forming a non-foamed skin layer on an outer surface of the foamed part; a skin-layer removing step of removing part of the skin layer in a predetermined pattern shape and exposing the foamed part; and a conductor-layer forming step of forming a conductor layer on the exposed foamed part by electroless plating or vapor deposition.

According to another aspect of the manufacturing method of the printed circuit board of the present invention, the foaming step is carried out after the resin is injection-molded into a predetermined shape.

According to another aspect of the manufacturing method of the printed circuit board of the present invention, the foaming step is carried out at the same time as injection molding of pellets of the predetermined resin into which a predetermined gas has been permeated.

According to another aspect of the manufacturing method of the printed circuit board of the present invention, the foamed part is exposed by melting the part of the skin layer by laser irradiation in the skin-layer removing step.

According to another aspect of the manufacturing method of the printed circuit board of the present invention, the foamed part is exposed by mechanically removing the part of the skin layer in the skin-layer removing step.

According to another aspect of the manufacturing method of the printed circuit board of the present invention, the resin is PPS.

According to another aspect of the manufacturing method of the printed circuit board of the present invention, the foamed part comprises bubbles having a foaming diameter of 10 µm or less.

According to another aspect of the manufacturing method of the printed circuit board of the present invention, the foamed part has a specific inductive capacity of 2 or less.

A first aspect of a printed circuit board of the present invention is a printed circuit board formed by using a predetermined resin, the printed circuit board having: a foamed part having a foamed structure formed in at least part of an interior of the resin; a skin layer formed on an outer surface of the foamed part and having no foamed structure; and a conductor layer in close contact with a surface of the foamed part from which the skin layer has been removed.

Another aspect of the printed circuit board of the present invention further has: a penetrating hole penetrating through the conductor layer formed on the surface of the resin in a first side, the skin layer formed on the surface thereof in a second side, and the foamed part.

Another aspect of the printed circuit board of the present invention further has: two said conductor layers formed on opposing surfaces of the resin, respectively, and a through hole penetrating through the foamed part and having a conductor layer on its inner surface so as to electrically connect the two conductor layers.

A first aspect of an antenna of the present invention is an antenna formed by using a predetermined resin, the antenna having: a foamed part having a foamed structure formed in at least part of an interior of the resin; a skin layer formed on an outer surface of the foamed part and having no foamed structure; and a conductor layer in close contact with a surface of the foamed part from which the skin layer has been removed in a predetermined antenna pattern shape; wherein the conductor layer operates as an antenna element.

Another aspect of the antenna of the present invention further has: a cable holder part formed so that part of the resin is in close contact with a sheath of a RF cable, wherein the conductor layer is formed at the position of the cable holder part in close contact with the sheath, and the sheath and the conductor layer are soldered with each other.

A first aspect of an antenna device of the present invention has a case part; an antenna pattern fixed to an inner surface side of the case part; and a foamed layer having a foamed structure and disposed between the antenna pattern and the inner surface of the case part.

According to another aspect of the antenna device of the present invention, a recessed part having a predetermined depth is formed on the inner surface of the case part; and the foamed layer is disposed in an interior of the recessed part.

According to another aspect of the antenna device of the present invention, the antenna pattern is formed on a surface of the foamed layer.

According to another aspect of the antenna device of the present invention, the antenna pattern is formed on a first-side surface of a predetermined antenna board, and a second-side surface of the antenna board is placed on the foamed layer and is fixed by a predetermined fixing means.

According to another aspect of the antenna device of the present invention, the antenna pattern is formed on a first-side surface of the foamed layer, and a second-side surface of the foamed layer is fixed to the inner surface of the case part.

According to another aspect of the antenna device of the present invention, the antenna pattern is a mobile terminal configured to be able to carry out transmission/reception even during moving.

A first aspect of a manufacturing method of an antenna device of the present invention is a manufacturing method of an antenna device having a case part, an antenna pattern fixed to an inner surface side of the case part, and a foamed layer having a foamed structure and disposed between the antenna pattern and the inner surface of the case part; the manufacturing method including: a first step of injection-molding the case part by using a first resin to which metal does not easily adhere; a second step of forming the foamed layer by using a second resin to which metal easily adheres; and a third step of forming the antenna pattern on a predetermined antenna board.

According to another aspect of the manufacturing method of the antenna device of the present invention, a recessed part is formed at a predetermined position of the case part in the first step, and the foamed layer is formed in an interior of the recessed part in the second step.

According to another aspect of the manufacturing method of the antenna device of the present invention, the first step and the second step are processed by two-color molding.

According to another aspect of the manufacturing method of the antenna device of the present invention, the antenna board is the foamed layer.

According to another aspect of the manufacturing method of the antenna device of the present invention, conductive paste is printed in the shape of the antenna pattern in the third step.

Another aspect of the antenna device of the present invention has an antenna board formed of a foamed dielectric resin having heat resistance and a predetermined dielectric constant; an antenna pattern formed on a first-side surface of the antenna board; a feed board composed of a board material having rigidity with which cutting resistance that allows at least formation of a penetrating hole is obtained; and a feed line formed on a first-side surface of the feed board; wherein a second-side surface of the antenna board and a second-side surface of the feed board are joined by a predetermined joining means.

According to another aspect of the antenna device of the present invention, a joining layer is formed by using a tacky producer or an adhesive agent as the joining means.

Another aspect of the antenna device of the present invention further has a metal pin having a first end soldered on the antenna pattern and a second end penetrating through the antenna board and electrically connected to the feed line.

According to another aspect of the antenna device of the present invention, the second end of the metal pin is further penetrating through the feed board and soldered on the feed line.

According to another aspect of the antenna device of the present invention, the metal pin is surface-mounted on the second-side surface of the feed board, and the second end of the metal pin is connected to a through hole electrically connected to the feed line.

According to another aspect of the antenna device of the present invention, the antenna pattern is connected to a first through hole penetrating through the antenna board, the feed line is connected to a second through hole penetrating through the feed board, and part between the second-side surface of the antenna board and the second-side surface of the feed board is soldered as the joining means, the part including electrical connection between the first through hole and the second through hole.

According to another aspect of the antenna device of the present invention, the foamed dielectric resin is foamed PPS or foamed LCP.

According to another aspect of the antenna device of the present invention, the foamed dielectric resin is MC-PPS (microcellular polyphenylene sulfide resin) having a specific inductive capacity of 2 or less and a foaming diameter of 10 µm or less in volume average.

A first aspect of a wireless communication device of the present invention is a wireless communication device having, in a chassis: one or more antenna part, a high-frequency circuit part connected to the antenna part to carry out a predetermined communication process, and a circuit board having a first-side surface equipped with the high-frequency circuit part and a second-side surface on which a main ground plane is formed; wherein each antenna radiation conductor part of the one or more antenna part is formed on a low-loss base material; an antenna radiation conductor part of at least one of the antenna part and an input/output part of the high-frequency circuit are disposed to be away from each other by a predetermined distance or more; a signal line is connected to the antenna radiation conductor part of the antenna part disposed to be away therefrom and formed of a conductor pattern on a first-side surface of the low-loss base material to a position of the input/output part; a transmission line part that forms a microstrip line by disposing the signal line with an interval defined by the thickness of the low-loss base material from a ground pattern formed on a second-side surface of the low-loss base material is further provided; and an end part of the signal line in a side opposite to the antenna radiation conductor part is connected to the input/output part by a predetermined elastic member, and two or more points on the ground pattern including vicinities of both end parts of the signal line are electrically connected to the main ground plane via another elastic member.

According to another aspect of the wireless communication device of the present invention, two or more said antenna parts are provided to carry out MIMO (Multiple-Input Multiple-Output) operation in at least one receiving band.

According to another aspect of the wireless communication device of the present invention, the antenna radiation conductor part is formed on one surface or both surfaces of the low-loss base material excluding a region in which the ground pattern is formed.

According to another aspect of the wireless communication device of the present invention, the antenna radiation conductor part of the antenna part and the input/output part disposed to be away from each other are away from each other by 50 mm or more.

According to another aspect of the wireless communication device of the present invention, the thickness of the low-loss base material is 0.2 mm or more.

According to another aspect of the wireless communication device of the present invention, the low-loss base material has flexibility and can be housed by being deformed along the shape of the chassis.

According to another aspect of the wireless communication device of the present invention, the low-loss base material is a resin foam containing independent bubbles in its interior.

According to another aspect of the wireless communication device of the present invention, the resin foam has a foaming diameter of the independent bubbles of 20 µm or less.

According to another aspect of the wireless communication device of the present invention, the low-loss base material and the ground pattern of the transmission line part have a width of 8 mm or less, and the transmission line part is bent at about 90 degrees with respect to the antenna radiation conductor part and disposed along a wall surface of the chassis.

According to another aspect of the wireless communication device of the present invention, the transmission line part is disposed so that the ground pattern is directed toward the wall surface side of the chassis.

According to another aspect of the wireless communication device of the present invention, the circuit board is equipped with two or more circuit blocks and has a metal frame for electromagnetically separating the circuit blocks; the low-loss base material and the ground pattern forming the transmission line part have a width equivalent to that of the circuit board; and the ground pattern is pushed against and placed on the metal frame.

According to another aspect of the wireless communication device of the present invention, the ground pattern has a thickness of 100 µm or more.

According to another aspect of the wireless communication device of the present invention, on the surface of the low-loss base material on which the signal line is formed, a thermal diffusing pattern connected to the ground pattern via a through hole is formed to be away from the signal line by 200 µm or more.

### Advantageous Effects of Invention

According to the present invention, a low-loss printed circuit board, a low-loss wide-band antenna, and manufacturing methods thereof can be provided by using a resin as a board material.

Moreover, according to the present invention, an antenna device having low dielectric loss and reduced influence from external objects and manufacturing methods thereof can be provided.

Moreover, according to the present invention, an antenna device using a foamed dielectric resin which imparts low-loss and wide-band characteristics to an antenna board can be provided.

Furthermore, according to the present invention, a wireless communication device provided with a low-cost transmission line capable of transmitting signals at low loss between an antenna and a high-frequency circuit part can be provided.

### Brief Description of Drawings

[Figure 1] Figure 1 shows processing-step views explaining a manufacturing method of a printed circuit board of a first embodiment of the present invention.
[Figure 2] Figure 2 shows a top view, a cross-sectional view, and a bottom view showing an example of the printed circuit board of the first embodiment.
[Figure 3] Figure 3 shows processing-step views explaining a manufacturing method of a printed circuit board of a second embodiment of the present invention.
[Figure 4] Figure 4 shows processing-step views explaining a manufacturing method of a printed circuit board of a third embodiment of the present invention.
[Figure 5] Figure 5 shows processing-step views explaining a manufacturing method of an antenna of a fourth embodiment of the present invention.
[Figure 6] Figure 6 shows schematic configuration drawings of an antenna and a printed circuit board for an antenna of a fifth embodiment of the present invention.
[Figure 7] Figure 7 shows schematic configuration drawings of another printed circuit board for an antenna of the fifth embodiment of the present invention.
[Figure 8] Figure 8 shows processing-step views explaining a manufacturing method of the printed circuit board of a sixth embodiment of the present invention.
[Figure 9] Figure 9 shows processing-step views explaining a manufacturing method of a printed circuit board of a seventh embodiment of the present invention.
[Figure 10] Figure 10 shows a comparative example of a printed circuit board manufactured by removing all of skin layers.
[Figure 11] Figure 11 shows processing-step views explaining a manufacturing method of a printed circuit board of an eighth embodiment of the present invention.
[Figure 12] Figure 12 shows processing-step views explaining a manufacturing method of a printed circuit board of a ninth embodiment of the present invention.
[Figure 13] Figure 13 shows processing-step views explaining a manufacturingmethod of a printed circuit board of a tenth embodiment of the present invention.
[Figure 14] Figure 14 shows a cross-sectional view and a plan view of an antenna device of an eleventh embodiment of the present invention.
[Figure 15] Figure 15 shows step views for explaining a manufacturing method of the antenna device of the eleventh embodiment of the present invention.
[Figure 16] Figure 16 shows a cross-sectional view and a plan view of an antenna device of a twelfth embodiment of the present invention.
[Figure 17] Figure 17 shows step views for explaining a manufacturing method of the antenna device of the twelfth embodiment of the present invention.
[Figure 18] Figure 18 shows cross-sectional views and plan views for explaining an antenna device and a manufacturing method thereof of a thirteenth embodiment of the present invention.
[Figure 19] Figure 19 shows cross-sectional views and plan views for explaining an antenna device and a manufacturing method thereof of a fourteenth embodiment of the present invention.
[Figure 20] Figure 20 shows a cross-sectional view and a plan view of an antenna device of a fifteenth embodiment of the present invention.
[Figure 21] Figure 21 shows, in an enlargedmanner, a cross-sectional view and a plan view of the vicinity of an antenna pattern of a conventional antenna device.
[Figure 22] Figure 22 shows, in an enlarged manner, a cross-sectional view and a plan view of the vicinity of an antenna pattern of another conventional antenna device.

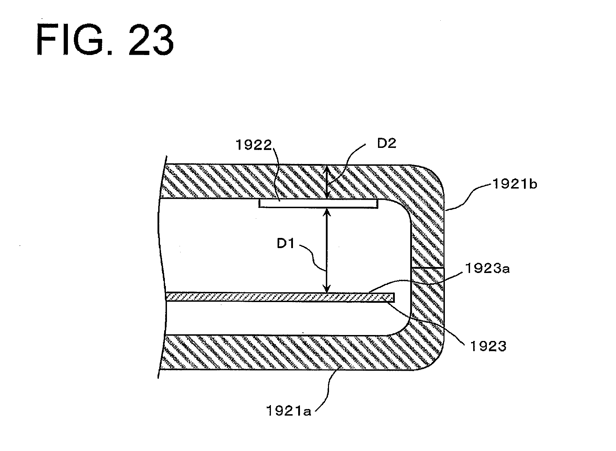

[Figure 23] Figure 23 shows a cross-sectional view showing the distances from an antenna pattern to a back side case part and a ground on a control board in a conventional antenna device.
[Figure 24] Figure 24 shows a top view, a cross-sectional view, and a bottom view showing a configuration of an antenna device of a sixteenth embodiment of the present invention.
[Figure 25] Figure 25 shows cross-sectional views showing examples of a foamed dielectric resin used in the antenna device of the sixteenth embodiment.
[Figure 26] Figure 26 shows step views showing amanufacturingmethod of the antenna device of the sixteenth embodiment.
[Figure 27] Figure 27 shows step views showing another manufacturing method of the antenna device of the sixteenth embodiment.
[Figure 28] Figure 28 shows cross-sectional views showing configurations of an antenna device of a seventeenth embodiment of the present invention.
[Figure 29] Figure 29 is a cross-sectional view showing a configuration of an antenna device of an eighteenth embodiment of the present invention.
[Figure 30] Figure 30 is a cross-sectional view showing a configuration of an antenna device of further another embodiment of the present invention.
[Figure 31] Figure 31 shows cross-sectional views showing configurations of an antenna device of a nineteenth embodiment of the present invention.
[Figure 32] Figure 32 shows a bottom view and a cross-sectional view showing a configuration of a wireless communication device according to a twentieth embodiment of the present invention.
[Figure 33] Figure 33 shows a bottom view showing a partial configuration of a wireless communication device according to a twenty-first embodiment of the present invention.
[Figure 34] Figure 34 shows a bottom view and a cross-sectional view showing a configuration of a wireless communication device according to a twenty-second embodiment of the present invention.
[Figure 35] Figure 35 shows a bottom view and a cross-sectional view showing a configuration of a wireless communication device according to a twenty-third embodiment of the present invention.
[Figure 36] Figure 36 shows a bottom view and a lateral view of a conventional wireless communication device in which no transmission-line integrated antenna is built.

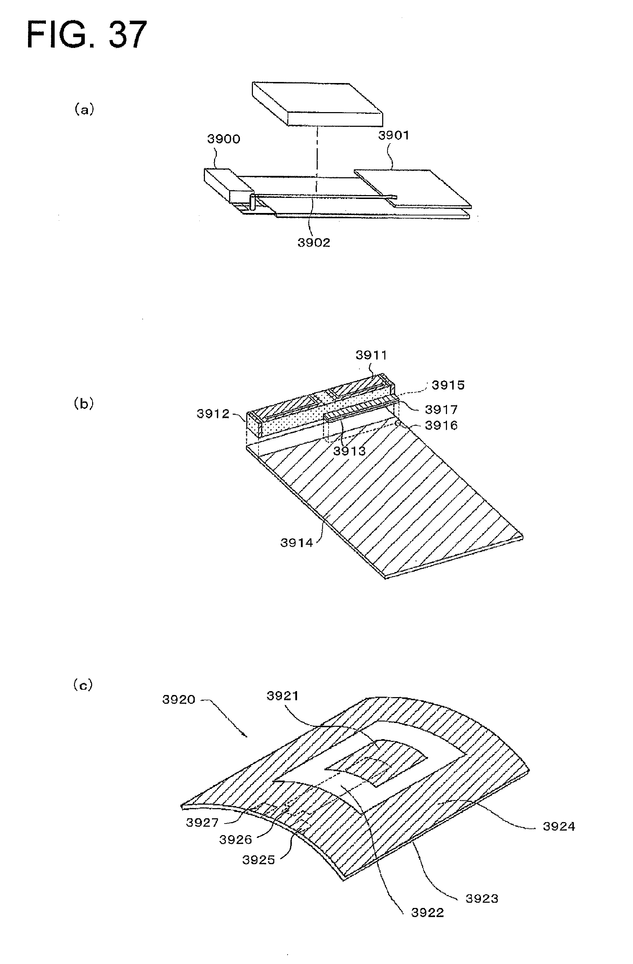

[Figure 37] Figure 37 shows perspective views of a conventional example of a transmission line which connects an antenna and a high-frequency circuit part.

### Description of Embodiments

Printed circuit boards, antennas, wireless communication devices, and manufacturing methods thereof of preferred embodiments of the present invention will be explained in detail with reference to drawings. Constituent parts having the same function are denoted by the same reference numerals in order to simplify illustration and explanations.
In the printed circuit boards, the antennas, and the manufacturing methods thereof in the present invention, resin-made boards having low dielectric constants are provided in order to realize low loss and wide bands.

### (First Embodiment)

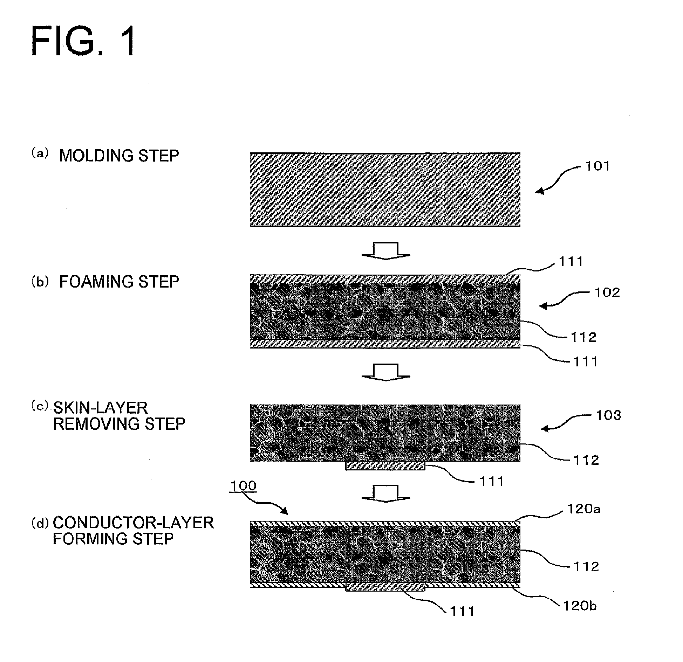

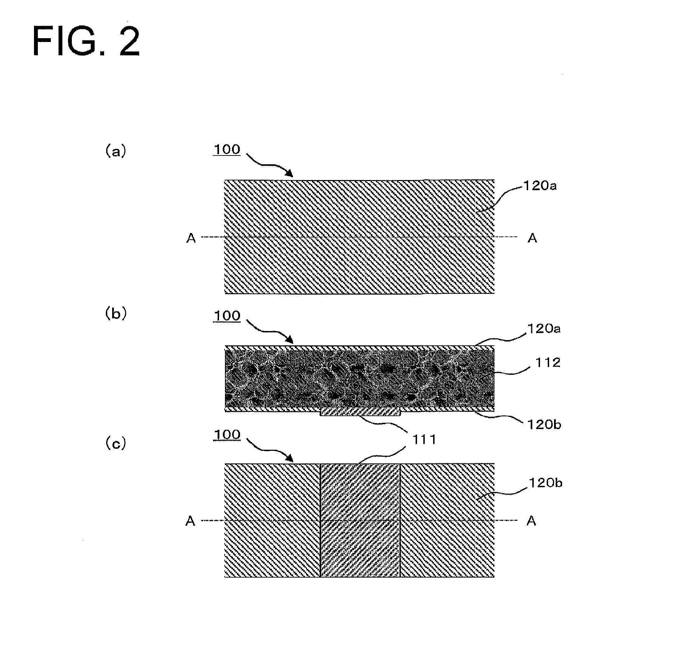

The printed circuit board and the manufacturing method thereof according to the first embodiment of the present invention will be explained below by using Figures 1 and 2. Figure 1 shows processing-step views explaining the manufacturing method of the printed circuit board of the present embodiment, and Figure 2 shows a top view ((a) of this drawing), a cross sectional view ((b) of this drawing), and a bottom view ((c) of this drawing) showing an example of the printed circuit board of the present embodiment. The cross-sectional view shown in (b) of this drawing is a cross-sectional view taken when cut by a cross section A-A shown in (a) and (c) of this drawing.

The printed circuit board 100 of the present embodiment shown in Figure 2 has a foamed part 112 formed by foaming the interior of a predetermined resin material, and the surfaces thereof are covered with a skin layer 111 and conductor layers 120. In this case, the conductor layer in the upper-surface side is 120a, the conductor layer in the bottom-surface side is 120b, and they are simply referred to as the conductor layers 120 when both of them are described together. The skin layer 111 is a surface layer which remains up to a predetermined depth from the surface without being foamed when the resin material is foamed, and the skin layer does not have a foamed structure. The conductor layers 120 are formed by plating or vapor-depositing a predetermined metal after the skin layer 111 is removed, and layers of the predetermined metal are in close contact with the foamed layer 112.

The foamed part 112 has a structure which has undergone a foaming process by causing a predetermined gas to permeate into the interior of the resin material, and the gas has a large volume ratio therein. Since the dielectric constant of the gas is lower than the dielectric constant of the resin material, the dielectric constant of the foamed part 112 can be caused to be smaller than that of the resin material. Therefore, this can be used as a printed circuit board having a low dielectric constant. Since the dielectric constant is reduced, the band thereof can be widened. The dielectric tangent thereof (tanδ) is also reduced together with the dielectric constant, and the circuit board with low loss can be provided. When such a low-dielectric-constant low-loss printed circuit board 100 is used in an antenna for high frequencies, a wide-band highly-efficient antenna can be prepared. It is preferred that the foamed part 112 is formed so as to have a specific inductive capacity of 2 or less.

The conductor layers 120 are formed, for example, by plating or vapor-depositing copper on the foamed part 112. The printed circuit board 100 shown in Figure 2 can be formed into, for example, a sheet-like shape having a thickness of about 1 mm. Alternatively, the board may be a molded body having an arbitrary shape. In Figure 2, the conductor layer 120a is configured to be formed on the upper surface ((a) of this drawing), and the skin layer 111 and the conductor layer 120b are configured to be formed on the bottom surface ((c) of this drawing); however, the configuration is not limited thereto, and the skin layer 111 and the conductor layer 120 can be appropriately formed on each of the upper surface and the bottom surface.

Examples of the resin material which is suitable for preparing the printed circuit board 100 of the present embodiment include: PPS (polyphenylene sulfide resin), PP (polypropylene resin), and PC (polycarbonate resin). Particularly, PPS has high heat resistance and has soldering heat resistance that is necessary for a board to be soldered. Examples of the usable resin having heat resistance include SPS (syndiotactic polystyrene) and PEEK (polyether ether ketone) in addition to PPS.

Next, the manufacturing method of the printed circuit board of the present embodiment will be explained below by using step views shown in Figure 1. The step views shown in Figure 1 show steps of manufacturing the print circuit board 100, which is shown in Figure 2 as an example. This case shows an example in which a general method conventionally used in plating of an ABS resin is applied to a resin having a foamed structure similar to that of the present embodiment.

First, in a molding step shown in Figure 1 (a), a resin material 101 is prepared by injection-molding a resin such as PPS used in manufacturing of the circuit board 100. The resin material 101 is formed into, for example, a sheet-like shape having a predetermined thickness. Alternatively, the resin material may be formed into a molded body having a predetermined shape. Injection molding into an arbitrary shape can be carried out when a resin is used.

In a next foaming step shown in Figure 1 (b), a predetermined gas (for example, carbon dioxide) is caused to dissolve in the interior of the resin material 101 to form bubbles. As a result, a foamed resin material 102 having the foamed part 112, which has the foamed structure in the interior thereof, is prepared. The size of the bubbles of the foamed part 112 is preferred to be, for example, 10 µm or less and is more preferred to be 1 to 3 µm or less. By virtue of this, an anchor effect that brings plating into close contact is obtained when a plating process is carried out. Moreover, the specific inductive capacity of the foamed part 112 can be caused to be 2 or less. As a method of preparing the foamed resin material 102 having such a fine structure, for example, a manufacturing method of MC (microcellular) can be used.

In Figure 1, the resin material 101 is prepared by injection molding in the molding step, and the foamed resin material 102 is prepared by foaming the interior thereof in the foaming step thereafter. However, the method is not limited to this, and the foamed resinmaterial 102 can be prepared by using a different method. For example, pellets of a predetermined resin into which a predetermined gas has been permeated can be used to subject them to injection molding and foam the interior thereof at the same time. The foamed resin material 102 may be prepared by such a method.

When the resin material 101 is foamed by the method as described above, the skin layer 111 in which bubbles are not formed remains on the surface thereof. The skin layer 111 has a structure with which it is difficult to bring plating into close contact with the surface thereof since the layer does not have bubbles. Therefore, in a skin-layer removing step of Figure 1 (c), the skin layer 111 is removed along a conductor pattern to expose the foamed part 112 in the interior. The foamed resin material from which the skin layer 111 has been removed in the skin-layer removing step will be hereinafter referred to as a patterned foamed resin material 103.

The foamed part 112 has the anchor effect that brings metal into close contact since the foamed part has many bubbles. As a method of removing the skin layer 111, there is a removing method in which the skin layer 111 is melted by irradiation with laser. In this method, the irradiation position of laser light can be controlled with high accuracy, and the predetermined conductor pattern can be stably formed with high accuracy. As another method of removing the skin layer 111, the skin layer 111 can be also removed mechanically by using, for example, a drill.

In a next conductor-layer forming step shown in Figure 1 (d), the patterned foaming resin material 103 is subjected to surface treatment, catalyst application, and treatment of catalyst activation and then subjected to electroless plating with a predetermined metal. The skin layer 111 cannot bring the metal into close contact, and the conductor layer 120 is not formed thereon. On the other hand, the many bubbles have been formed on the exposed foamed part 112 from which the skin layer 111 has been removed; therefore, the metal is well brought into close contact therewith, and the conductor layer 120 can be formed. If the conductor layer 120 having a sufficient thickness cannot be formed only by the electroless plating, electrolytic plating may be further carried out. If the conductor layer 120 is not required to be formed to be thick, the conductor layer 120 may be formed by vapor deposition in the conductor-layer forming step.

As explained above, according to the manufacturing method of the printed circuit board of the present embodiment, since the skin layer 111 is removed along the conductor pattern to expose the foamed part 112 in the skin-layer removing step, the metal can be brought into close contact only with the exposed part of the foamed part 112 in the conductor-layer forming step, and the conductor layer 120 having a desired pattern can be formed.

In the manufacturing method of the printed circuit board of the present embodiment, as a result of removing the skin layer 111 along the predetermined conductor pattern, the conductor layer 120 can be directly formed on the foamed part 112 by electroless plating. By virtue of the anchor effect provided by the foamed part 112, the conductor layer 120 is strongly brought into close contact with the foamed part 112. According to the present embodiment, as a result of causing the skin layer 111 to remain in the part where the conductor layer 120 is not necessary, the conductor layer 120 having the predetermined pattern can be formed only by the electroless plating. Therefore, in the present embodiment, the necessity of carrying out etching is eliminated.

As explained above, according to the present embodiment, the low-loss wide-band printed circuit board and the manufacturing method thereof can be provided by using the resin as the board material. Moreover, by utilizing the fact that the dielectric constant of the foamed part 112 of the present embodiment becomes low, efficiency can be improved by reducing dielectric loss, and the available band can be widened. In the present embodiment, as a result of removing the skin layer 111 along the conductor pattern, the conductor layer 120 can be formed by bringing the metal into close contact directly only with the exposed foamed part 112, and the necessity of an etching process can be eliminated. The cost of the manufacturing method of the printed circuit board of the present embodiment is low since the degree of freedom of the shape of the circuit board and the degree of freedom of wiring of the conductor pattern are high, and only one mold is required. Moreover, design change of the circuit pattern can be managed by changing a program of a manufacturing apparatus, and manageability with respect to the design change is high. A general material such as PPS can be used as the resin of the board material. The foamed part 112 is preferred to be formed so as to have a specific inductive capacity of 2 or less.

### (Second Embodiment)

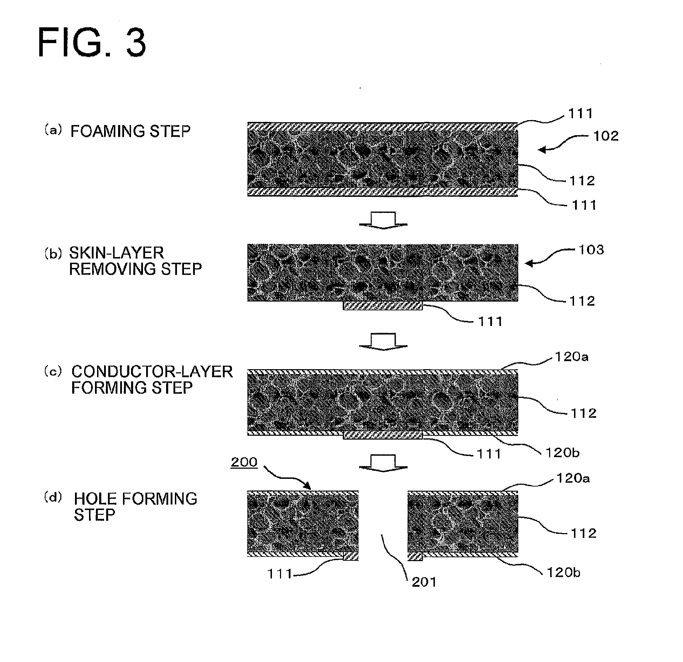

The second embodiment of the printed circuit board and the manufacturing method thereof of the present invention will be explained below by using Figure 3. Figure 3 shows processing-step views explaining the manufacturing method of the printed circuit board of the second embodiment. The present embodiment provides the printed circuit board, in which a penetrating hole is formed, and the manufacturing method thereof. Figure 3 (a) shows the sheet-shaped foamed resin material 102, which has been prepared by a molding step and a foaming step similar to those of the first embodiment and has an entire interior having a foamed structure. As well as the first embodiment, PPS is preferred to be used as the resin for forming the foamed resin material 102.

Next, in Figure 3 (b), as well as the skin-layer removing step of the first embodiment, the skin layers 111 are removed along conductor patterns. As a result, the foamed part 112 is exposed at the positions where the conductor patterns are to be formed. Then, in a conductor-layer forming step of Figure 3 (c), electroless plating is carried out with a predetermined metal as well as the first embodiment. As a result, only the exposed foamed part 112 is plated, and the conductor layers 120 having the predetermined conductor patterns are formed.

In the present embodiment, furthermore, in a hole forming step shown in Figure 3 (d), a penetrating hole 201 perpendicularly penetrating through the skin layer 111, which has been remaining without being removed, is formed. The penetrating hole 201 can be mechanically formed by using, for example, a drill. As a result, the printed circuit board 200 of the present embodiment is formed. The penetrating hole 201 like this can be used for, for example, disposing a line which is electrically connected from the bottom surface side of the printed circuit board 200 to the conductor layer 120a in the upper surface side without being electrically connected to the conductor layer 120b.

### (Third Embodiment)

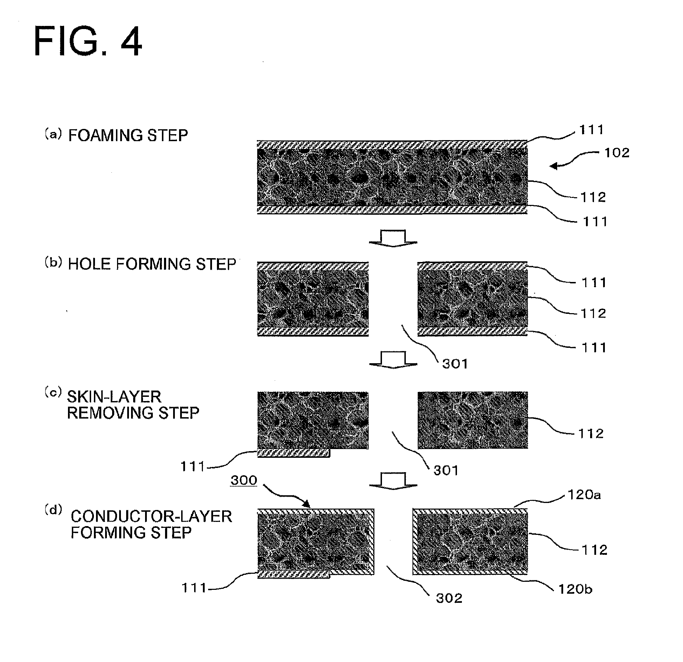

The third embodiment of the printed circuit board and the manufacturing method thereof of the present invention will be explained below by using Figure 4. Figure 4 shows processing-step views explaining the manufacturing method of the printed circuit board of the third embodiment. The present embodiment provides the printed circuit board, in which a through hole is formed, and the manufacturing method thereof. Figure 4 (a) shows the sheet-shaped foamed resin material 102, which has been prepared by a molding step and a foaming step similar to those of the first embodiment and has an entire interior having a foamed structure. As well as the first embodiment, PPS is preferred to be used as the resin for forming the foamed resin material 102.

Then, in the present embodiment, in a hole forming step shown in Figure 4 (b), a penetrating hole 301 is formed at a predetermined position. The penetrating hole 301 can be mechanically formed by, for example, using a drill. In a skin-layer removing step shown in Figure 4 (c), the skin layers 111 are removed along conductor patterns as well as the first embodiment. In the present embodiment, the skin layers 111 around the penetrating hole 301 are removed. Then, in a conductor-layer forming step shown in Figure 4 (d), electroless plating with a predetermined metal is carried out as well as the first embodiment. As a result, the printed circuit board 300 of the present embodiment is formed.

In the printed circuit board 300 prepared by the manufacturing method of the present embodiment, the inner surface of the penetrating hole 301 is plated and formed into the through hole 302. More specifically, in the present embodiment, since the penetrating hole 301 is formed before the conductor-layer forming step, the predetermined metal is plated also on the inner surface of the penetrating hole 301 in the conductor-layer forming step. Since the inner surface of the penetrating hole 301 is the foamed layer 112, the anchor effect by the foamed layer 112 is obtained. Therefore, the through hole 302 electrically connecting the conductor layer 120a, which is formed in the upper surface side of the printed circuit board 300, and the conductor layer 120b, which is formed in the bottom surface side, is formed.

A multilayer board can be prepared by stacking a plurality of the printed circuit boards 300 of the present embodiment. In that case, a through hole penetrating through the entire multilayer board can be formed by electrically connecting the through holes 302 formed in the layers thereof. Alternatively, a through hole penetrating from the board of a predetermined layer to the bottom surface of the multilayer board can be formed.

### (Fourth Embodiment)

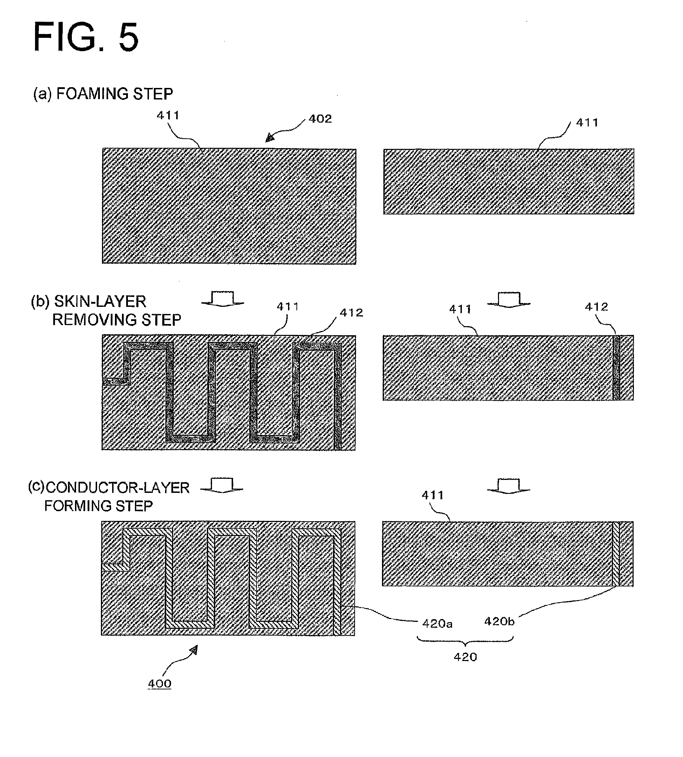

The antenna and the manufacturing method thereof, which are the fourth embodiment of the present invention, will be explained below by using Figure 5. In the present embodiment, the antenna 400 equipped with a chip antenna is prepared. Figure 5 shows processing-step views explaining the manufacturing method of the antenna 400 of the fourth embodiment and is explaining the steps by using top views (left side in the drawing) and lateral views (right side in the drawing).

Figure 5 (a) shows a foamed resin material 402 having an interior, in which a foamed part 412 having a foamed structure is formed, and having a surface all of which is covered with a skin layer 411. The foamed resin material 402 has been prepared by molding into a molded body having a predetermined shape in a molding step similar to that of the first embodiment and subjecting this to a foaming step to foam the entire interior thereof. Alternatively, the foamed resin material 402 may be prepared by using pellets of a predetermined resin into which a predetermined gas has been permeated, subjecting them to injection molding, and foaming the interior thereof at the same time. As well as the first embodiment, PPS is preferred to be used as the resin for forming the foamed resin material 402.

Then, in a skin-layer removing step shown in Figure 5 (b), the skin layer 411 on the upper surface is irradiated with laser along a predetermined antenna pattern. As a result, the skin layer 411 is melted and removed in the shape of the antenna pattern. A lateral surface thereof is also irradiated with laser to remove the skin layer 411 in the shape of a feed line. As a result, the foamed part 412 is exposed in the same shape as that of the antenna pattern and the feed line. In a conductor-layer forming step shown in Figure 5 (c), a conductor layer 420 is formed in the exposed foamed part 412 by electroless plating. As a result, the antenna 400 provided with the conductor layer 420 of the predetermined antenna pattern (denoted by a reference numeral 420a) and the feed line (denoted by a reference numeral 420b) is prepared.

The antenna 400 of the present embodiment prepared in the above described manner can be used as a chip antenna. An LDS method can be used as a method of manufacturing the chip antenna; however, in this method, a special resin mixed with, for example, a metal filler has to be used, and there has been a problem that cost becomes high. On the other hand, in the manufacturing method of the antenna 400 of the present embodiment, there is no need to use a special resin, and the antenna can be prepared by using, for example, PPS. Since the conductor layer 420 of the antenna pattern is formed on the foamed part 412 having a low dielectric constant, a wide-band low-loss chip antenna can be realized. Furthermore, the antenna 400 of the present embodiment can be surface-mounted on, for example, a printed circuit board.

### (Fifth Embodiment)

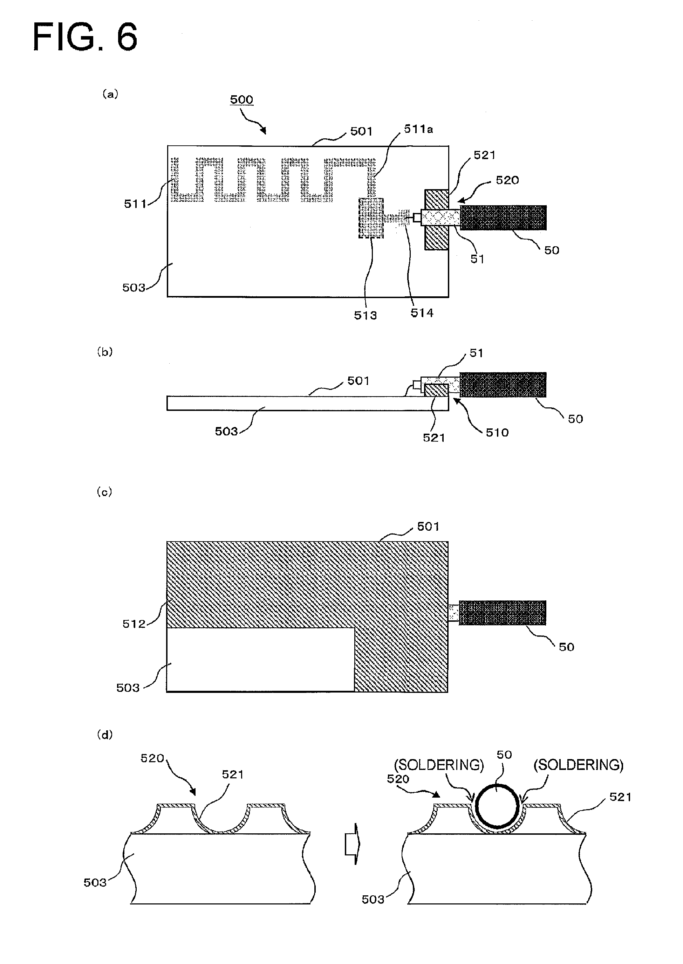

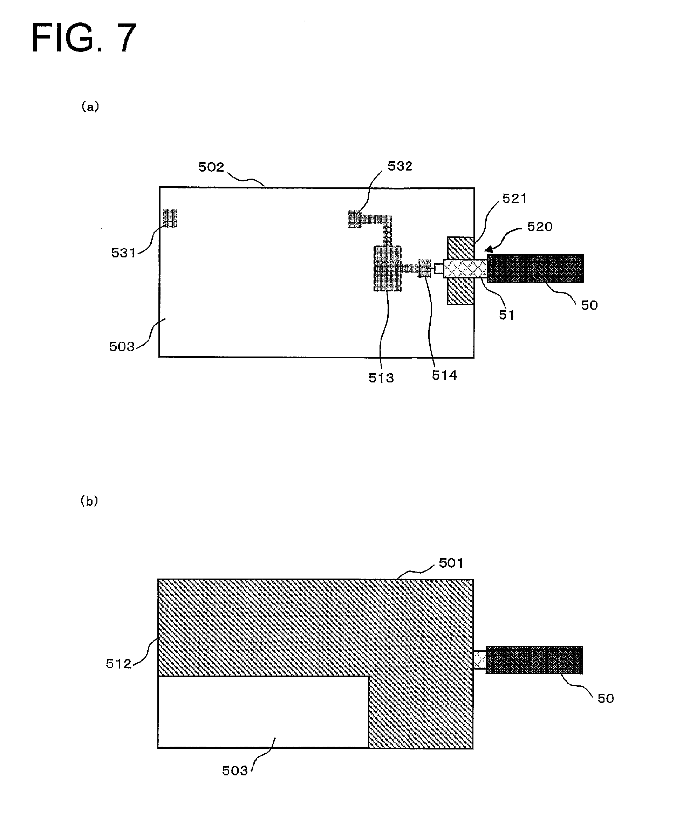

The antenna, the printed circuit board for the antenna, and the manufacturing method thereof, which are the fifth embodiment of the present invention will be explained below by using Figures 6 and 7. Figure 6 shows schematic configuration drawings of the antenna and the printed circuit board for the antenna of the fifth embodiment; wherein, (a) shows a top view, (b) shows a lateral view, (c) shows a bottom view, and (d) shows an enlarged lateral view of a cable holder part provided on the printed circuit board for the antenna of the present embodiment. Figure 7 shows schematic configuration drawings of the printed circuit board for the antenna of the present embodiment, which is configured so that the board can be equipped with a chip antenna; wherein (a) shows a top view, and (b) shows a bottom view.

The antenna 500 of the present embodiment shown in Figure 6 forms an antenna pattern 511 on the upper surface of the printed circuit board 501 and forms a ground (GND) pattern 512 on the bottom surface thereof. A feed line 511a of the antenna pattern 511 is connected to a pad 514 via a matching circuit part 513 provided with a chip component and a wiring pattern on the upper surface of the printed circuit board 501. The upper surface of the printed circuit board 501 is further provided with the cable holder part 520 so that an outside coaxial cable 50 can be easily connected. A core line of the RF cable 50 disposed at the cable holder part 520 is soldered to the pad 514.

As shown in Figure 6 (d), a GND pattern 521 is formed on the surface of the cable holder part 520. The GND pattern 521 is electrically connected to the GND pattern 512 formed on the bottom surface. A sheath part 51 of the RF cable 50 is directly attached to the cable holder part 520, and the sheath part 51 and the GND pattern 521 are soldered.

In the present embodiment, in a molding step, a predetermined resin is injection-molded into a predetermined shape having the shape of the cable holder part 520. Then, the entire interior thereof is foamed in a foaming step. Alternatively, the cable holder part may be prepared by using pellets of a predetermined resin into which a predetermined gas has been permeated, injection-molding them into a predetermined shape having the shape of the cable holder part 520, and foaming the interior thereof at the same time. PPS is preferred to be used as the predetermined resin.

Then, in a skin-layer removing step, a skin layer 503 at a predetermined position is irradiated with laser to melt and remove the layer. In this case, the skin layer 503 at the positions of the antenna pattern 511 on the upper surface, the feed line 511a, the pad 514, the GND pattern 521 on the surface of the cable holder part 520, and the GND pattern 512 of the bottom surface is removed. Also for the matching circuit part 513, the skin layer 503 can be removed into a required shape such as a wiring pattern. In a conductor-layer forming step subsequent to the skin-layer removing step, when electroless plating is carried out, the antenna pattern 511, the feed line 511a, the pad 514, the GND pattern 521 on the surface of the cable holder part 510, and the GND pattern 512 on the bottom surface are formed at the positions where the skin layer 503 has been removed. The antenna 500 prepared in the above described manner can be surface-mounted on, for example, another printed circuit board.

Another printed circuit board 502 for the antenna of the present embodiment shown in Figure 7 can be manufactured in a manner similar to that of the above described printed circuit board 501. However, in the printed circuit board 502 of the present embodiment, instead of forming the antenna pattern 511, pads 531 and 532 for mounting a chip antenna are formed. In this case, the pad 532 is formed so as to be connected to a feed line 533. All of these can be formed by irradiating the skin layer 503 with laser to form patterns thereof and then carrying out electroless plating. A predetermined chip antenna is surface-mounted on the pads 531 and 532.

### (Sixth Embodiment)

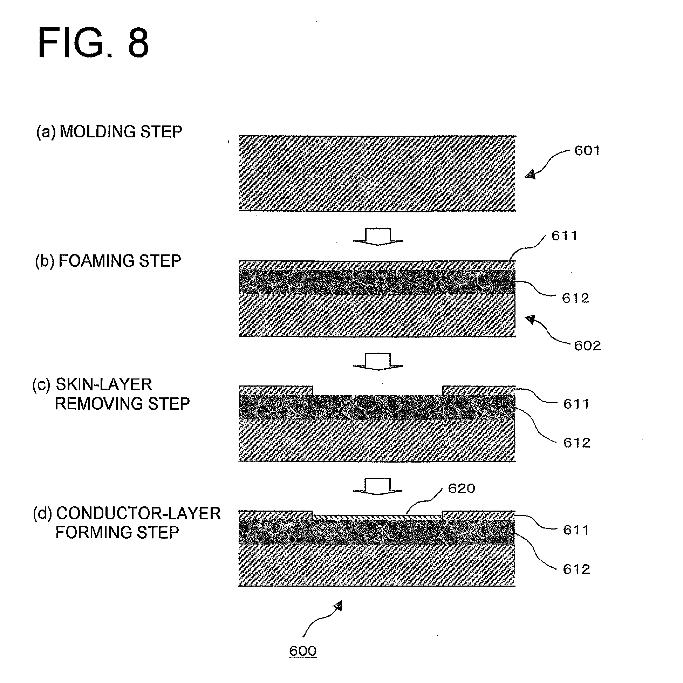

The printed circuit board and the manufacturing method thereof, which are the six embodiment of the present invention, will be explained below by using Figure 8. Figure 8 shows processing-step views explaining the manufacturing method of the printed circuit board 600 of the sixth embodiment of the present invention. The present embodiment employs a structure in which a foamed part 612 having a foamed structure is utilized only as an anchor of plating. More specifically, only the region in which the conductor layer 620 is formed by plating is foamed so as to prepare the foamed part 612.

Figure 8 (a) shows a resin material 601 prepared by a molding step. PPS or PC (polycarbonate resin) is preferred to be used as the resin that forms the resin material 601. In a foaming step shown in next Figure 8 (b), a foamed resin material 602 is prepared by foaming only the upper surface side of the resin material 601 on which the conductor layer 620 is to be formed. It is preferred that the foamed part 612 having, for example, a thickness of about several tens of µm be prepared below a skin layer 611 in the upper surface side.

In a skin-layer removing step shown in Figure 8 (c), the skin layer 611 is removed along a conductor pattern. As a result, the foamed part 612 is exposed at the position where the conductor pattern is to be formed. In a subsequent conductor-layer forming step of Figure 8 (d), electroless plating is carried out with a predetermined metal. As a result, only the exposed foamed part 612 is plated, and the conductor layer 620 having the predetermined conductor pattern is formed.

Methods of partially foaming the resin material 601 in the above described foaming step will be explained below. As the first method of foaming only the vicinity of the surface of the resin material 601, there is a method of controlling the time for placing the resin material 601 in a predetermined gas (carbon dioxide) to cause the gas to permeate thereinto. The gas permeates thereinto from the surface side of the resinmaterial 601; therefore, when the time for causing the gas to permeate thereinto is shortened, the gas can be caused to permeate into and foam only the vicinity of the surface of the resin material 601. As the second method, the gas is caused to permeate into the entirety of the resin material 601, wherein only the vicinity of the surface of the resin material 601 can be foamed by shortening the foaming time.

In the printed circuit board 600 of the present embodiment, the foamed part 612 is formed to be thin; therefore, reduction in the strength of the board can be suppressed. Moreover, since the effect of reducing the dielectric constant of the board is comparatively small, this is suitable for utilization in those other than antennas which do not require low dielectric constants.

### (Seventh Embodiment)

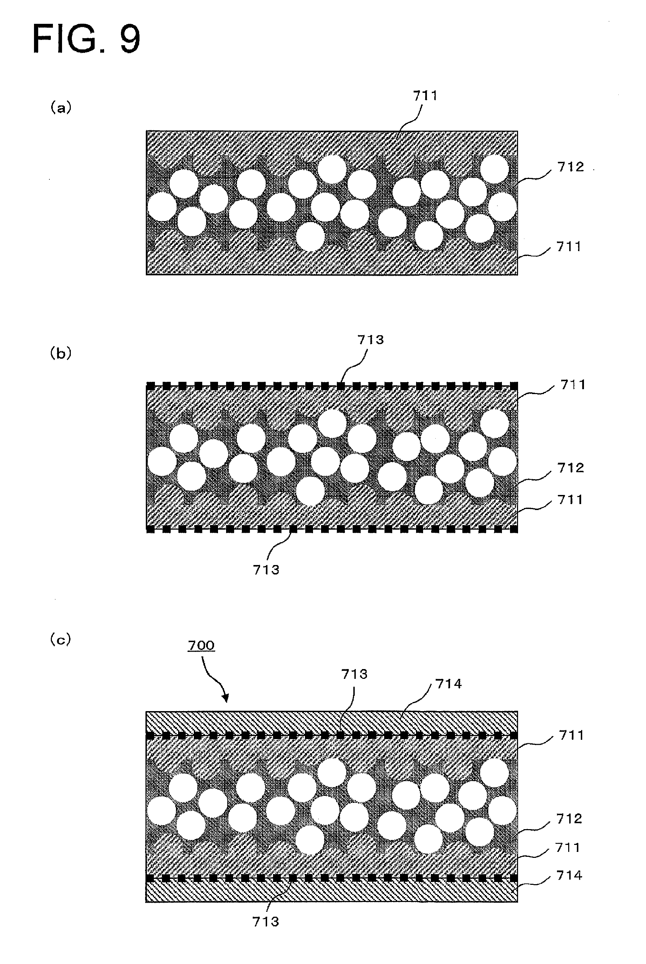

The printed circuit board and the manufacturing method thereof according to the seventh embodiment of the present invention will be explained below by using Figure 9. Figure 9 shows processing-step views explaining the manufacturing method of the printed circuit board of the present embodiment. Figure 9 (c) shows a cross-sectional view of the printed circuit board of the present embodiment.

In the manufacturing methods of the printed circuit boards of the first embodiment, etc. , the foamed layer in the interior is exposed by removing only the skin layer at the part where the conductor pattern of the foamed resin material is to be formed, and, for example, electroless plating is carried out with the predetermined metal after carrying out treatment such as catalyst application, thereby forming the conductor layer. In such a manufacturing method, the skin layer remains at the part excluding the conductor pattern, and the metal is not brought into close contact with the skin layer; therefore, there has been no need to remove unnecessary plating, for example, by etching.

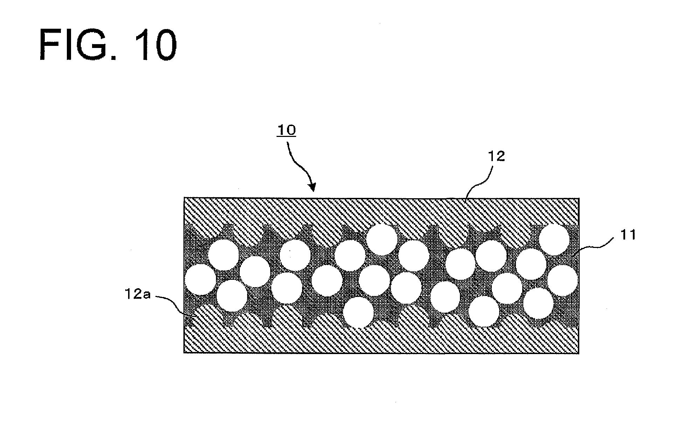

On the other hand, the printed circuit board can be manufactured by forming the conductor pattern after removing all of the skin layer of the foamed resin material. In the manufacturing method of the printed circuit board of the present embodiment, a method of manufacturing the printed circuit board after removing the entirety of the skin layer is provided. First, as a comparative example of the printed circuit board of the present embodiment, an example of a printed circuit board, which has been manufactured by removing all of the skin layers to expose the foamed part and subjecting it to plating, is shown in Figure 10.

The printed circuit board 10 of the comparative example shown in Figure 10 can be manufactured in a belowmanner after removing all of the skin layers of the foamed resin material to expose the foamed part 11 on the surface. First, the entire surface of the exposed foamed part 11 is subjected to electroless plating, the conductor layer 12 is then formed by subjecting only the positions of a predetermined pattern to electrolytic plating by a pattern forming method to increase the thickness thereof, and the unnecessary part of the electroless plating is then removed by etching. Alternatively, after the entire surface of the exposed foamed part 11 is subjected to electroless plating, the plating thickness of the entirety is increased by electrolytic plating to form the conductor layer 12, and unnecessary plating is then removed by etching.

In the case in which either one of the above described manufacturing methods is used, plating 12a may adhere to the deep position of the foamed part 11 other than the conductor layer 12 formed on the surface of the foamed part 11. Even when etching is carried out for removing the unnecessary plating 12a, an etching solution may not permeate to the position of the plating 12a, which has adhered to the deep position of the foamed part 11, and the plating 12a may remain. If the unnecessary plating 12a remains without complete removal thereof in this manner, variations in antenna characteristics, reduction in withstand voltage, etc. may be caused.

Therefore, in the manufacturing method of the printed circuit board of the present embodiment, the foamed resin material is formed in the steps shown in Figure 1 (a) and (b), all of the skin layers of the foamed resin material are removed in the step of Figure 1 (c), and, then, the surfaces of a foamed part 712 are coated with resin layers 711 so as to bury the foamed structure in a coating step shown in Figure 9 (a). In a next catalyst applying step shown in Figure 9 (b), a catalyst 713 is fixed to the surfaces of the resin layers 711 so that the surfaces of the resin layer 711 can be subjected to electroless plating. Then, in a plating-layer forming step shown in Figure 9 (c), electroless plating is applied onto the resin layers 711, and electrolytic plating is further applied thereon, thereby increasing the thickness of the plating and forming conductor layers 714. After the conductor layers 714 are formed on the resin layers 711, unnecessary plating is removed by etching to manufacture the printed circuit board 700 of the present embodiment.

As explained above, in the manufacturing method of the printed circuit board of the present embodiment, the surfaces of the foamed part 712 are coated with the resin layers 711, and the plating layers are formed thereon; therefore, there is no risk that the plating adheres to the deep position of the foamed part 712. Therefore, unnecessary plating can be removed by an etching process, and variations in antenna characteristics, reduction in withstand voltage, etc. can be prevented. Moreover, since the surfaces of the foamed part 712 are coated with the resin layers 711, high cohesion strength can be obtained even when a material which does not easily adheres such as PPS (polyphenylene sulfide) is used as the material of the foamed part 712.

### (Eighth Embodiment)

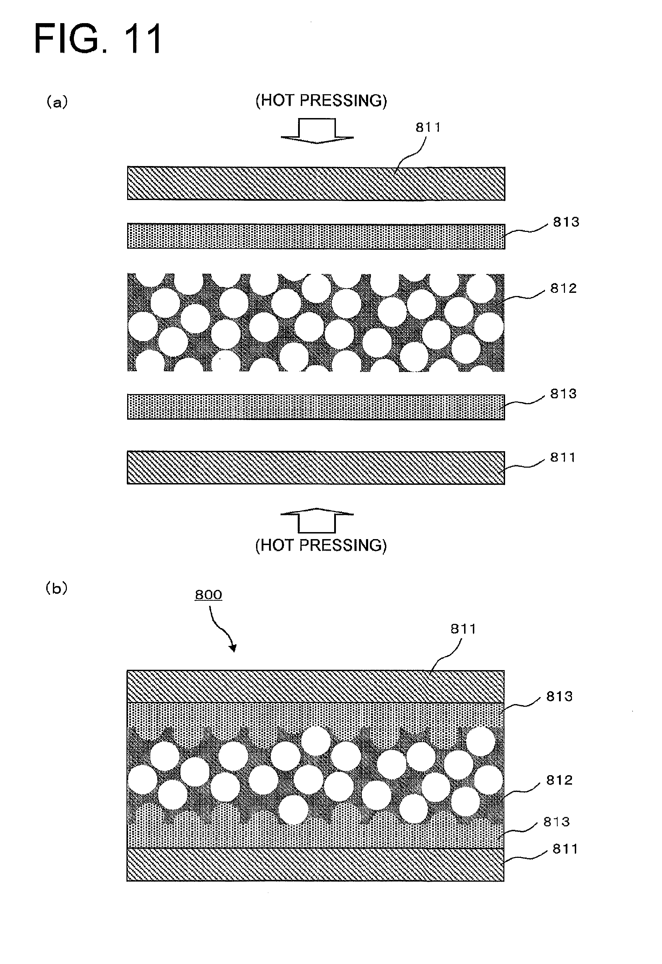

The printed circuit board and the manufacturing method thereof according to the eighth embodiment of the present invention will be explained below by using Figure 11. Figure 11 (a) is a step view explaining the manufacturing method of the printed circuit board of the present embodiment, and Figure 11 (b) shows a cross-sectional view of the printed circuit board of the present embodiment.

In the seventh embodiment, the catalyst application and electroless plating are carried out after the surfaces of the foamed part 712 are coated with the resin layers 711. However, instead of that, the present embodiment employs a manufacturing method in which metal foil (for example, copper foil) 811 is caused to adhere to a foamed part 812 by hot-pressing by using a hot-melt adhesive agent 813. In the manufacturing method of the printed circuit board shown in Figure 11 (a), the copper foil 811 is disposed on both surfaces of the foamed part 812 with the hot-melt adhesive agent 813 interposed therebetween, and hot pressing is carried out so as to press the two sheets of the copper foil 811 from upper and lower both sides of the drawing. As a result, the hot-melt adhesive agent 813 melts, and the copper foil 811 is fixed to the foamed part 812.

In the manufacturing method of the printed circuit board of the above explained present embodiment, the copper foil 811 is fixed only to the surfaces of the foamed part 812, and there is no risk that the copper foil adheres to the interior thereof. Therefore, occurrence of variations in antenna characteristics, reduction in withstand voltage, etc. can be prevented. Instead of the hot-melt adhesive agent, a thermosetting adhesive agent (for example, prepreg) can be also used.

### (Ninth Embodiment)

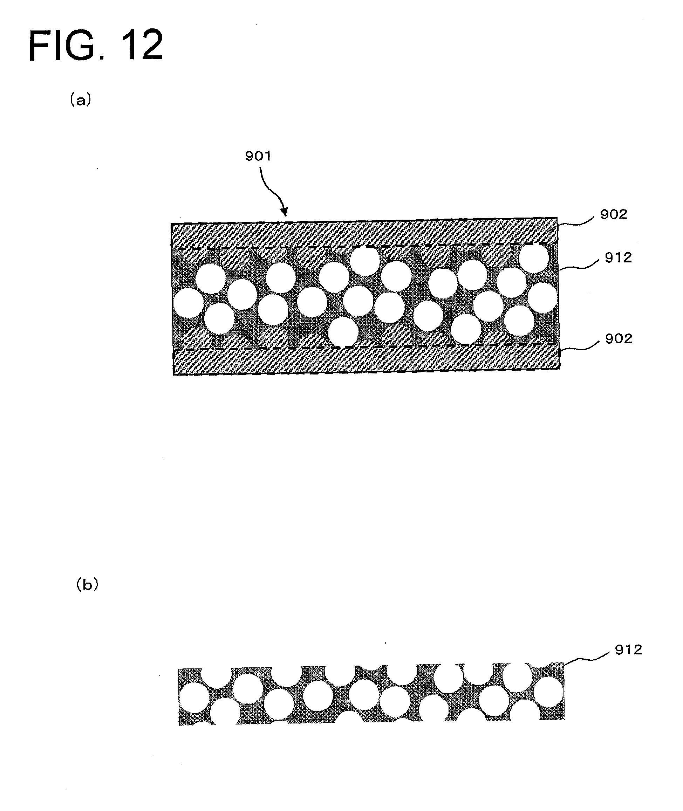

The printed circuit board and the manufacturing method thereof according to the ninth embodiment of the present invention will be explained below by using Figure 12. Figure 12 shows processing-step views explaining the method of manufacturing a foamed part 912 as the manufacturing method of the printed circuit board of the present embodiment.

In the above described embodiments, a resin is injection-molded into a predetermined size to prepare a resin material (molding step), and it is subjected to gas permeation and then heating to form a foamed structure (foaming step). In this manufacturing method, in the short period from the permeation of the gas into the resin material until foaming is carried out by heating in the foaming step, the gas on the surfaces of the film-shaped resin material is discharged, and the skin layers are formed on the surfaces without formation of the foamed structure.

In order to prepare a printed circuit board having flexibility, the foamed part has to be formed to be like a thin film. In order to form a thin film-shaped foamed part by using the above described manufacturing method, a foamed resin material has to be prepared by forming a thin film-shaped resin material in the molding step and foaming this in the foaming step. However, if the thickness of the resin material is reduced, most part of the foamed resin material prepared in the foaming step becomes the skin layers, and the effect of foaming in the foaming step cannot be really obtained.

Therefore, in the manufacturing method of the printed circuit board of the present embodiment, a foamed part 912 having no skin layer 902 shown in Figure 12 (b) is formed by forming a thick film-shaped foamed resin material 901 shown in Figure 12 (a) in a molding step and a foaming step and thinly slicing the material. The foamed structure of the foamed part 912 is exposed on the surface; therefore, in a next step, instead of directly subjecting the surfaces of the foamed part 912 to plating, as well as the seventh embodiment or the eighth embodiment, the surfaces of the foamed part 912 are coated with resin layers so as to bury the foamed structure, and the surfaces of the resin layers are subjected to catalyst application and then subjected to electroless plating and electrolytic plating. As a result, a thin printed circuit board having flexibility is obtained.

### (Tenth Embodiment)

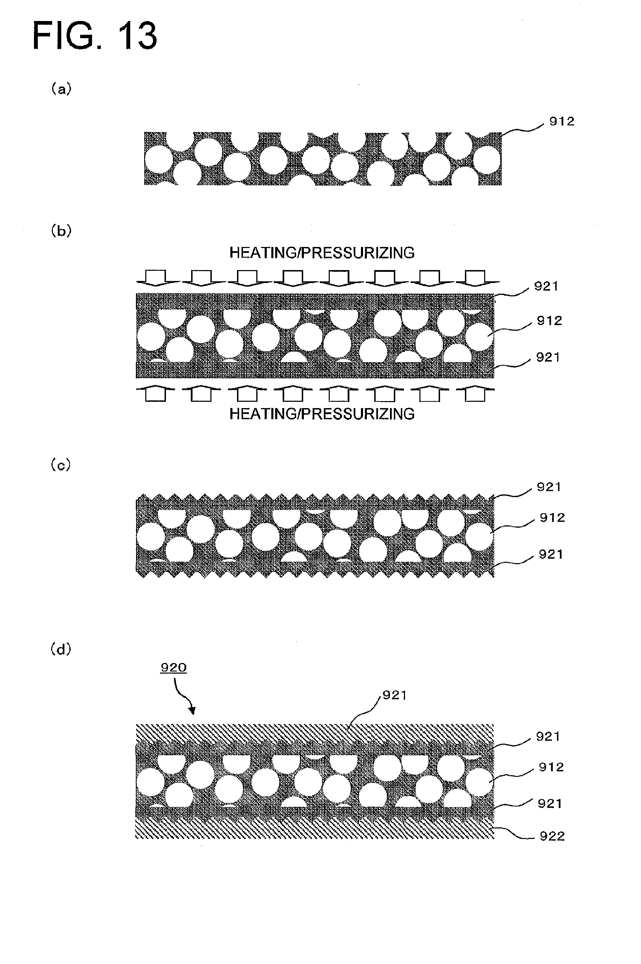

The printed circuit board and the manufacturing method thereof according to the tenth embodiment of the present invention will be explained below by using Figure 13. Figure 13 shows processing-step views explaining the manufacturing method of the printed circuit board of the present embodiment. Figure 13 (d) shows a cross-sectional view of the printed circuit board of the present embodiment.

In the manufacturing method of the printed circuit board of the ninth embodiment, the thick film-shaped foamed resin material 901 is sliced to form the thin film-shaped foamed part 912, and the surfaces of the foamed part 912 are coated with the resin layers and then subjected to plating. On the other hand, the present embodiment provides a method of manufacturing the printed circuit board 920 while maintainingflexibility without coating the surfaces of the foamed part 912 with the resin layers.

The thin film-shaped foamed part 912 obtained by slicing the foamed resin material 901 is shown in Figure 13 (a). Heat and pressures are applied to the foamed part 912 from the both surfaces thereof in a heating pressurizing step shown in Figure 13 (b). As a result, the surfaces of the foamed part 912 are melted to form melt layers 921, and the foamed structure exposed on the surfaces are covered with the melt layers 921. In a next surface roughening step shown in Figure 13 (c), the surfaces of the melt layers 921 are roughened, for example, by sandblasting. Then, in a next conductor-layer forming step shown in Figure 13 (d), conductor layers 922 are formed by carrying out electroless plating and electrolytic plating.

According to the manufacturing method of the printed circuit board of the present embodiment, the thickness of the board can be further reduced compared with the printed circuit board prepared by the manufacturing method of the ninth embodiment, in which the resin layers are formed. Moreover, there is no need to provide the resin layers which have a higher dielectric constant and a higher dielectric tangent than those of the foamed layer, and electric characteristics also become more advantageous.

Hereinafter, mobile terminals will be explained as examples of antenna devices of the present invention; however, the antenna devices are not limited thereto, but may be, for example, car-mounted antennas mounted in a car. In a normal mobile terminal, a case part, which houses an antenna pattern, etc., is separated into a front side case part and a back side case part; therefore, the case part will be hereinafter explained separately in two parts, i.e., the front side case part and the back side case part. The configuration of the case part is not limited to this, but may be a single body or divided into three or more.

### (Eleventh Embodiment)

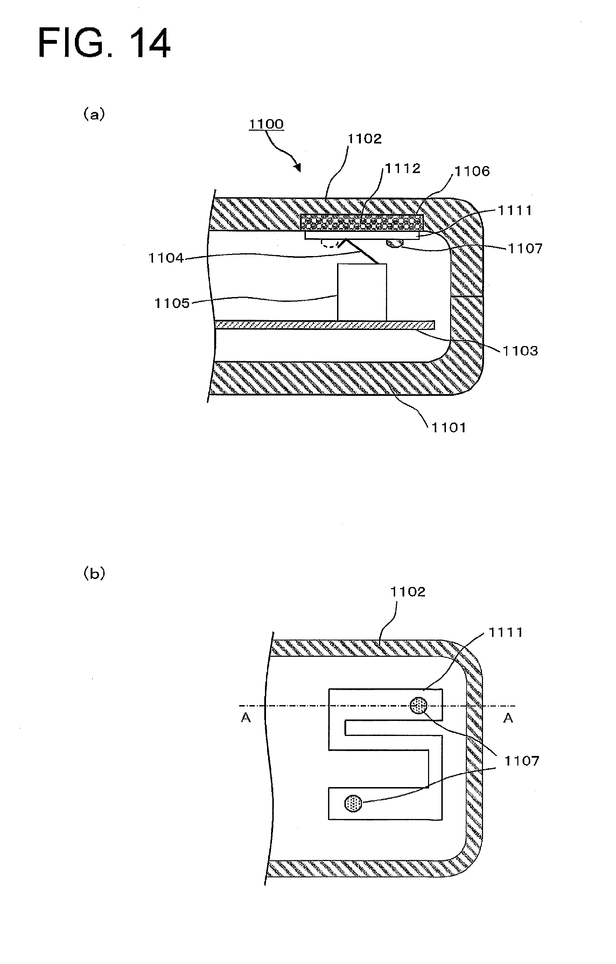

The antenna device according to the eleventh embodiment of the present invention will be explained below by using Figure 14. Figure 14 shows a configuration of the antenna device of the present embodiment; wherein (a) of this drawing shows a cross-sectional view of the antenna device 1100, and (b) of this drawing shows a plan view. The cross-sectional view shown in Figure 14 (a) is a cross-sectional view taken along a line AA of the plan view shown in Figure 14 (b). In the antenna device 1100 of the present embodiment, an antenna pattern 1111, a control board 1103, etc. are built in the interior of a case, which consists of a front side case part 1101 and a back side case part 1102.

In the antenna device 1100 of the present embodiment, a recessed part 1106 is formed at a predetermined position on an inner surface of the back side case part 1102, and a foamed layer 1112 is formed in the interior of the recessed part 1106. As the foamed layer 1112, foamed ABS (acrylonitrile butadiene styrene), to which a metal easily adheres, can be used. As a resin material for forming the front side case part 1101 and the back side case part 1102, for example, PC or PPS, to which a metal does not easily adhere, can be used. Not only ABS, but also various resins foamed can be used as the foamed layer 1112.

The back side case part 1102, which has the recessed part 1106 like this, and the foamed layer 1112 in the interior thereof can be integrally manufactured by a two-color molding method as described later. As anothermanufacturingmethod, the foamed layer 1112 can be separately manufactured in advance and can be fitted in the recessed part 1106; however, higher strength can be obtained by the manufacturing using the two-color molding method.

In the present embodiment, the foamed layer 1112 serves as an antenna board, and the antenna pattern 1111 is placed on a surface thereof. The antenna pattern 1111 can be formed of a sheet metal composed of, for example, SUS or phosphor bronze and having a thickness of about 0.1 to 0.2 mm as well as conventional cases. Welding bosses 1107 are provided in advance on the back side case part 1102, and, after the antenna pattern 1111 is disposed on the foamed layer 1112, the welding bosses 1107 are melted to fix it. It is preferred that the welding bosses 1107 do not have a foamed structure in order to ensure the strength thereof.

On the other hand, a feed terminal 1104 held by a terminal holding part 1105 is placed on the control board 1103 mounted in the front side case part 1101 side. When the front side case part 1101 and the back side case part 1102 are mated with each other, the antenna pattern 1111 is electrically connected to the control board 1103 by the feed terminal 1104 as well as conventional cases. In the present embodiment, both of the distance D1 from the antenna pattern 1111 to a ground on the control board 1103 and the distance D2 from the antenna pattern 1111 to the outer surface of the back side case part 1102 are the same as those of a conventional antenna device 1900 shown in Figure 21.

The foamed layer 1112 is formed to have a foamed structure containing a gas in the interior thereof and has a low dielectric constant since the dielectric constant of a resin serving as a material of the foamed layer 1112 has been averagely reduced by a low dielectric constant of the gas. It is preferred that the foaming diameter of the foamed layer 1112 be configured to be 10 µm or less. It is also preferred that the dielectric constant of the foamed layer 1112 be configured to be 2 or less in the specific inductive capacity. As a result of placing the antenna pattern 1111 on the foamed layer 1112 having such a low dielectric constant, a dielectric loss (tan δ) is reduced, highly efficient antenna characteristics are obtained, and wide-band characteristics are obtained.

As a result of disposing the foamed layer 1112 having the low dielectric constant between the back side case part 1102 and the antenna pattern 1111, the electrical distance between the outer surface of the back side case part 1102 and the antenna pattern 1111 becomes long. As a result, even when an external object composed of a metal or a high dielectric body is disposed outside of the back side case part 1102, the influence exerted on the antenna pattern 1111 can be reduced. Furthermore, the foamed layer 1112 has characteristics that the foamed layer can be subj ected to patterning or bending at an equivalent degree as FPC.

In the present embodiment, the foamed layer 1112 having the low dielectric constant is used as the antenna board; therefore, the antenna pattern 1111 can be also formed by a method of conductive paste printing. If the antenna pattern 1111 is formed by the conductive paste printing method, there is a problem that the resistance value of the antenna pattern 1111 is increased and loss is increased; however, since the dielectric constant of the foamed layer 1112 serving as the antenna board is low and dielectric loss is reduced, loss caused by increase in the resistance value of the antenna pattern 1111 can be therefore compensated for. In the case in which the conductive paste printing method is used, the antenna pattern 1111 can be formed at low cost.

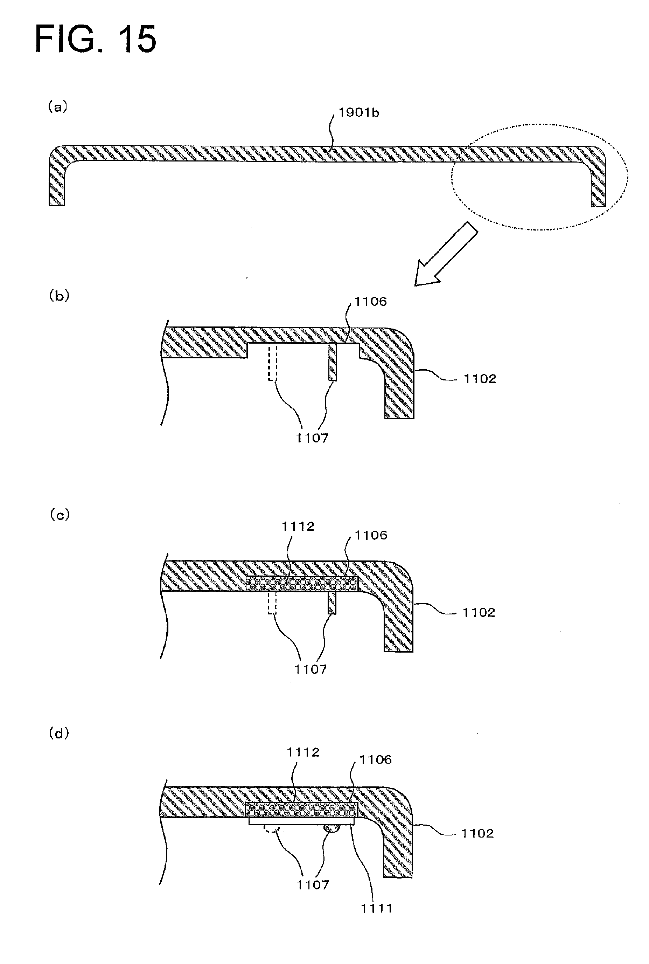

A manufacturing method of the antenna device 1100 of the present embodiment will be explained below by using Figure 15. Figure 15 shows step views for explaining the manufacturing method of the antenna device 1100 of the present embodiment. Figure 15 (a) shows a cross-sectional view of a back side case part 1901b of the conventional antenna device 1900. At this point, processing for mounting the antenna has not been particularly carried out. Figure 15 (b) to (d) are cross-sectional views showing, in an enlarged manner, part of the back side case part 1102 of the antenna device 1100 of the present embodiment.

In the antenna device 1100 of the present embodiment shown in Figure 15 (b), when the back side case part 1102 is formed by injection-molding a resin such as PC, the recessed parts 1106 and the welding bosses 1107 are formed at predetermined positions (positions surrounded by a broken line of Figure 15 (a)) on the inner surface thereof. Then, in a step shown in Figure 15 (c), the foamed layer 1112 is molded in the interior of the recessed part 1106. The foamed layer 1112 can be formed by injection-molding a predetermined resin material (such as ABS or PPS) and foaming the interior thereof at the same time. The above described injection molding of the back side case part 1102 and the injection molding of the foamed layer 1112 can be carried out by using a two-color molding method.

In a step of Figure 15 (d), the antenna pattern 1111 formed of a sheet metal, which is composed of, for example, SUS or phosphor bronze, and has a thickness of about 0.1 to 0.2 mm, is placed on the surface of the foamed layer 1112, and the welding bosses 1107 are welded therewith to fix the antenna pattern 1111. In the present embodiment, the antenna pattern 1111 is formed of a sheet metal; however, the method is not limited thereto, and the antenna pattern may be formed by another method.

As another method of forming the antenna pattern 1111, a method of forming the antenna pattern 1111 by etching after vapor-depositing a predetermined metal on the surface of the foamed layer 1112 can be used. Alternatively, a method of removing a skin layer, which is formed on the surface of the foamed layer 1112 and does not have a foamed structure, by, for example, laser along the shape of the antenna pattern 1111 and then forming the antenna pattern 1111 by electroless plating can be used. Furthermore, the antenna pattern 1111 can be formed at low cost by using the conductive paste printing method explained above.

### (Twelfth Embodiment)

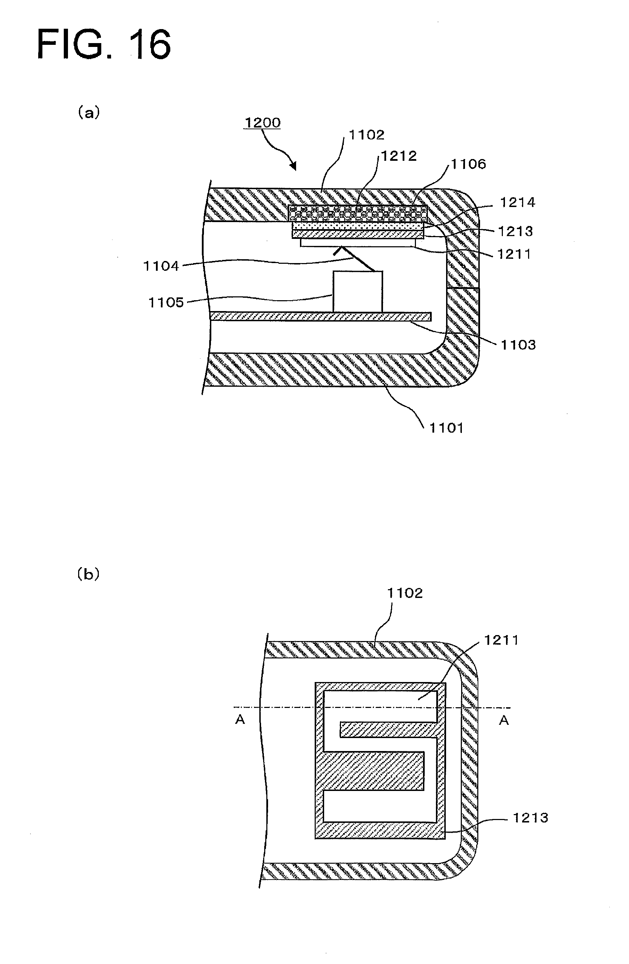

The antenna device according to the twelfth embodiment of the present invention will be explained below by using Figure 16. Figure 16 shows a configuration of the antenna device of the present embodiment; wherein, (a) of this drawing shows a cross-sectional view of the antenna device 1200, and (b) of this drawing shows a plan view. The cross-sectional view shown in Figure 16 (a) is a cross-sectional view taken along a line AA shown in Figure 16 (b).

Also in the present embodiment, the recessed part 1106 is formed at a predetermined position of the inner surface of the back side case part 1102 of the antenna device 1200, and a foamed layer 1212 is formed in the interior of the recessed part 1106. An antenna pattern 1211 is formed on a surface of a FPC 1213 serving as a base film, and this is adhering to the foamed layer 1212 with a double-sided tape (fixing means) 1214.

Also in the present embodiment, as a result of placing the antenna pattern 1211 on the foamed layer 1212, which has a low dielectric constant, with the FPC 1213 and the double-sided tape 1214 interposed therebetween, dielectric loss (tan δ) is reduced, highly efficient antenna characteristics are obtained, and wide-band characteristics are obtained. Moreover, as a result of disposing the foamed layer 1212, which has the low dielectric constant, between the back side case part 1102 and the antenna pattern 1211, the electric distance between the outer surface of the back side case part 1102 and the antenna pattern 1211 becomes long. As a result, even when an external object composed of a metal or a high dielectric body is disposed outside of the back side case part 1102, the influence exerted on the antenna pattern 1211 can be reduced. In the present embodiment, the FPC 1213 and the double-sided tape 1214 are further disposed between the back side case part 1102 and the antenna pattern 1211, the distance between the outer surface of the back side case part 1102 and the antenna pattern 1211 is correspondingly increased, and the influence of the external object can be further reduced.

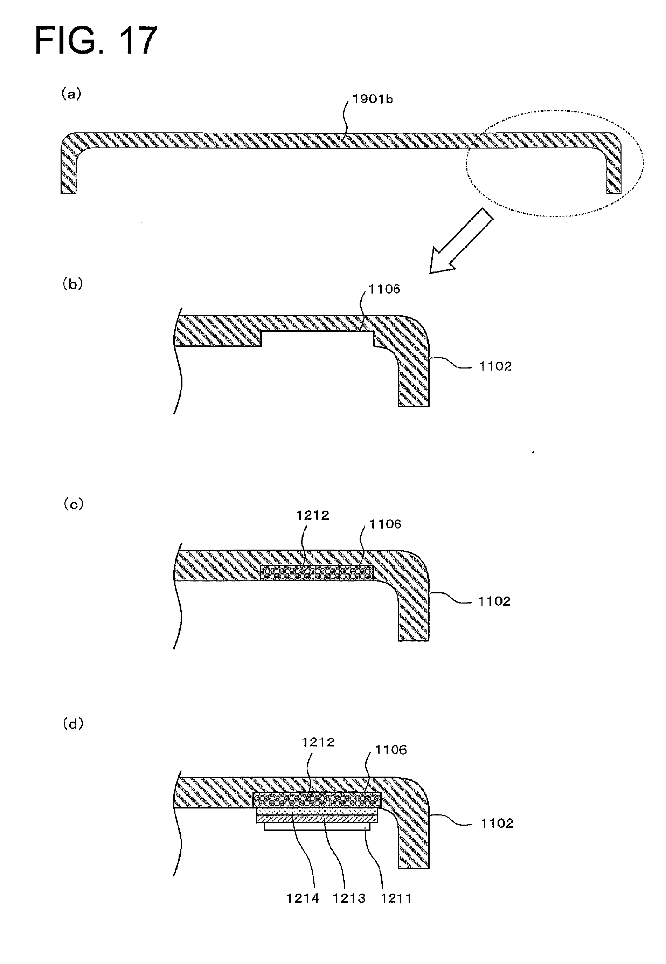

A manufacturing method of the antenna device 1200 of the present embodiment will be explained below by using Figure 17. Figure 17 shows step views for explaining the manufacturing method of the antenna device 1200 of the present embodiment. Figure 17 (a) shows a cross-sectional view of the back side case part 1901b of the conventional antenna device 1900, and Figures 17 (b) to (d) show, in an enlarged manner, cross-sectional views of part of the back side case part 1102 of the antenna device 1200 of the present embodiment.

In the antenna device 1200 of the present embodiment, when the back side case part 1102 is to be formed by injection-molding a resin (PC), the recessed part 1106 is formed on the inner surface thereof. In the present embodiment, formation of welding bosses is not required. Then, in a step shown in Figure 17 (c), the foamed layer 1212 is molded in the interior of the recessed part 1106. As well as the eleventh embodiment, the foamed layer 1212 can be formed by injection-molding a predetermined resin (such as ABS or PPS) and foaming the interior thereof at the same time. The injection molding of the back side case part 1102 and the injection molding of the foamed layer 1212 can be carried out by using the two-color molding method.

In the present embodiment, the antenna pattern 1211 is formed on the FPC 1213 in advance. In a step of Figure 17 (d), the FPC 1213 on which the antenna pattern 1211 is formed is fixed by adhesion to the surface of the foamed layer 1212 by using the double-sided tape 1214. As a method of forming the antenna pattern 1211 on the FPC 1213, a method of forming the antenna pattern 1211 by etching after vapor-depositing a predetermined metal on the surface of the FPC 1213 can be used. Alternatively, the antenna pattern 1211 can be formed at low cost by using the conductive paste printing method.

### (Thirteenth Embodiment)

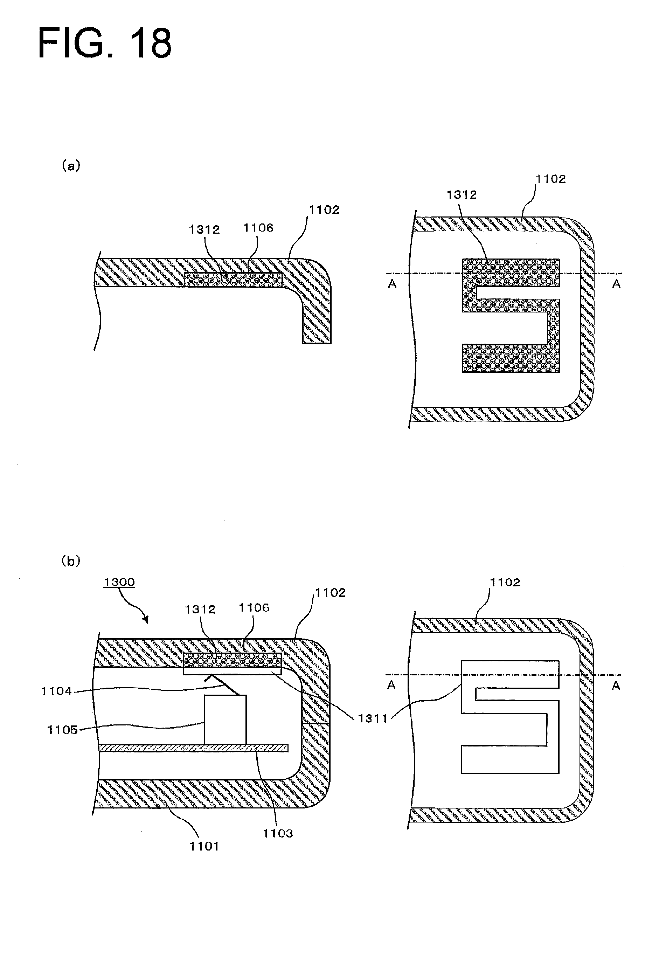

The antenna device and a manufacturing method thereof according to the thirteenth embodiment of the present invention will be explained below by using Figure 18. Figure 18 (a) shows a cross-sectional view (left side of the drawing) and a plan view (right side of the drawing) showing an intermediate step of manufacturing the antenna device of the present embodiment. Figure 18 (b) shows a cross sectional view (left side of the drawing) and a plan view (right side of the drawing) of the antenna device of the present embodiment. The cross-sectional views are cross-sectional views at lines AA of respective plan views.

Also in the present embodiment, the recessed part 1106 is formed at a predetermined position of the inner surface of the back side case part 1102 of the antenna device 1300, and a foamed layer 1312 is formed in the interior of the recessed part 1106. The foamed layer 1312 serves as an antenna board, and an antenna pattern 1311 is placed on the surface thereof.

In the present embodiment, the antenna pattern 1311 is formed by utilizing the anchor effect of the foamed layer 1312. After the back side case part 1102 and the foamed layer 1312 are inj ection-molded by the two-color molding method, in order to form the antenna pattern 1311, the skin layer formed on the surface of the foamed layer 1312 is removed by, for example, laser along the shape of the antenna pattern 1311 (Figure 18 (a)). Then, the antenna pattern 1311 is formed by electroless plating.

The foamed layer 1312 has the anchor effect that the foamed structure part from which the skin layer has been removed fixes a metal; on the other hand, the skin layer does not have the anchor effect. As a result, a predetermined metal is plated only on the foamed structure part from which the skin layer has been removed by electroless plating. As a result, the antenna pattern 1311 is formed. For example, ABS or PPS can be used as the resin material of the foamed layer 1312. PC can be used as the resin material of the front side case part 1101 and the back side case part 1102.

In the case in which the foamed layer 1312 serves as an antenna board and the antenna pattern 1311 is formed thereon like the present embodiment, below effects can be obtained by using the method of removing the skin layer by, for example, laser, and carrying out electroless plating (herein, referred to as a first method) compared with a method of forming the foamed layer with ABS and forming the antenna pattern by vapor deposition and etching (herein, referred to as a second method). First, the first method does not require a roughening step by chemical etching of ABS, which is required in the second method. In the first method, plating does not adhere to general materials (for example, PC) used in the case part, and the plating can be firmly fixed only on the part from which the skin layer has been removed by carrying out laser treatment (anchor effect of the foamed structure part). Therefore, the same material can be used for injection-molding the back side case part 1102 and the foamed layer 1312 by the two-color molding method. Even when the same material is used, plating can be firmly fixed only on the foamed layer 1312 side, which has been foamed, by laser treatment. When the same material is used, there are effects that the connection between the materials becomes firm and high reliability is obtained.

Also in the present embodiment, the antenna pattern 1311 is formed on the foamed layer 1312 having a low dielectric constant; therefore, dielectric loss (tan δ) is reduced, highly efficient antenna characteristics are obtained, and wide-band characteristics are obtained. As a result of disposing the foamed layer 1312, which has a low dielectric constant, between the back side case part 1102 and the antenna pattern 1311, the electrical distance between the outer surface of the back side case part 1102 and the antenna pattern 1311 becomes long. As a result, even when an external object composed of a metal or a high dielectric body is disposed outside of the back side case part 1102, the influence exerted on the antenna pattern 1311 can be reduced.

### (Fourteenth Embodiment)

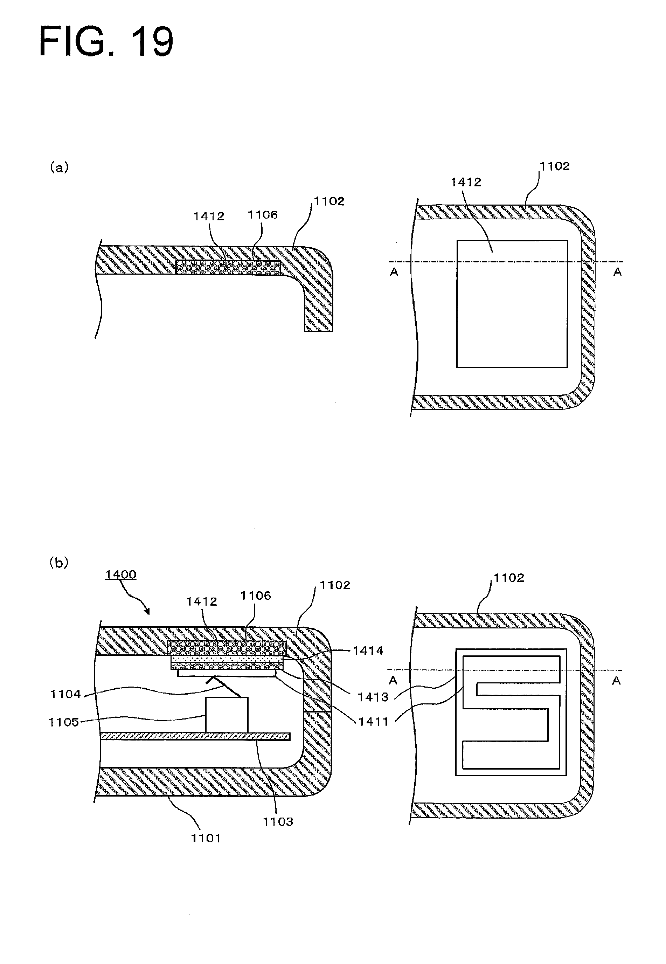

The antenna device and a manufacturing method thereof according to the fourteenth embodiment of the present invention will be explained below by using Figure 19. Figure 19 (a) shows a cross-sectional view (left side of the drawing) and a plan view (right side of the drawing) showing an intermediate step of manufacturing the antenna device of the present embodiment. Figure 19 (b) shows a cross-sectional view (left side of the drawing) and a plan view (right side of the drawing) of the antenna device of the present embodiment. The cross-sectional views are cross-sectional views at lines AA of respective plan views.

Also in the present embodiment, the recessed part 1106 is formed at a predetermined position of the inner surface of the back side case part 1102 of the antenna device 1400, and a foamed layer 1412 is disposed in the interior of the recessed part 1106. An antenna pattern 1411 is formed on the surface of a FPC 1413 serving as a base film, and this is adhering to the foamed layer 1412 with a double-sided tape 1414. In the present embodiment, the FPC 1413 also has a foamed structure in addition to the foamed layer 1412.

Also in the present embodiment, the back side case part 1102 and the foamed layer 1412 are inj ection-molded by the two-color molding method (Figure 19 (a)). At this point, in the plan view in the right side of Figure 19 (a), since the foamed layer 1412 is covered with a skin layer, the foamed structure as shown in the cross-sectional view cannot be seen. The FPC 1413 having a surface on which the antenna pattern 1411 is formed has been formed into a foamed structure in advance. Therefore, the FPC 1413 also has a low dielectric constant. After the back side case part 1102 and the foamed layer 1412 are injection-molded, the FPC 1413 having the foamed structure on which the antenna pattern 1411 is formed is caused to adhere to the foamed layer 1412 with the double-sided tape 1414.

In the present embodiment, the antenna pattern 1411 is formed on the FPC 1413 and the foamed layer 1412, which have foamed structures having low dielectric constants; therefore, dielectric loss (tan δ) is reduced, highly efficient antenna characteristics are obtained, and wide-band characteristics are obtained. Moreover, as a result of disposing also the low-dielectric-constant FPC 1413 in addition to the low-dielectric-constant foamed layer 1412 between the back side case part 1102 and the antenna pattern 1311, the electrical distance between the outer surface of the back side case part 1102 and the antenna pattern 1411 becomes long. As a result, even when an external object composed of a metal or a high dielectric body is disposed outside of the back side case part 1102, the influence exerted on the antenna pattern 1411 can be further reduced.

In the present embodiment, the antenna pattern 1411 is formed by vapor deposition or the conductive paste printing method; therefore, compared with the conventional antenna device 1900 formed by a mold and shown in Figure 21, the distance from the antenna pattern 1411 to a ground on the control board 1103 becomes long. As a result, antenna characteristics are further improved.

### (Fifteenth Embodiment)

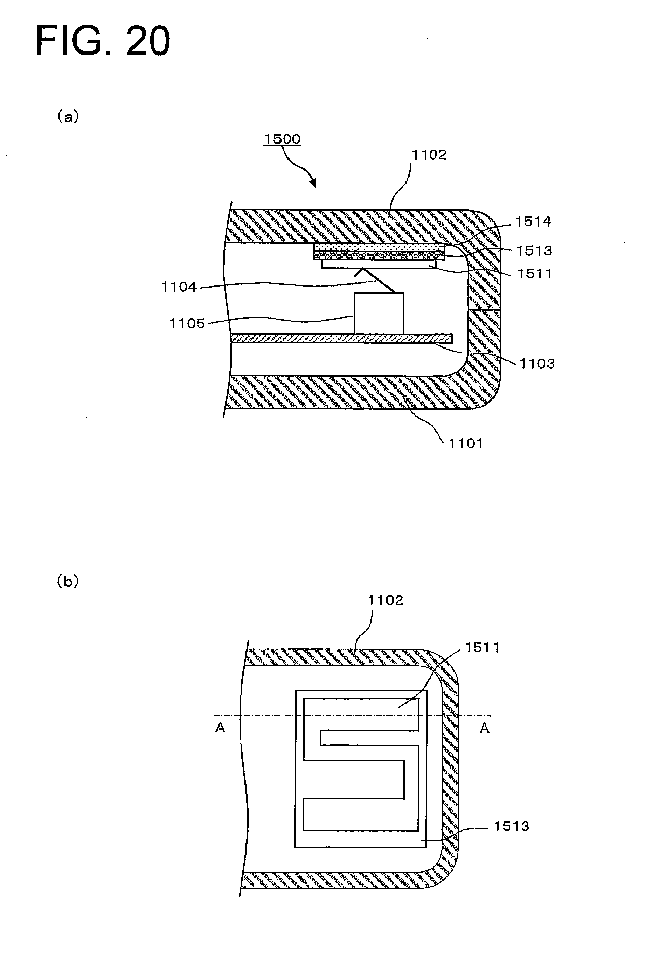

The antenna device and a manufacturing method thereof according to the fifteenth embodiment of the present invention will be explained below by using Figure 20. Figure 20 shows a cross-sectional view ((a) of the drawing) and a plan view ((b) of the drawing) of the antenna device of the present embodiment.

In the present embodiment, no recessed part is formed on the inner surface of a back side case part 1502 of the antenna device 1500, and no foamed layer is disposed either. In the present embodiment, as well as the antenna device 1400 of the fourteenth embodiment, an antenna pattern 1511 is formed on the surface of a FPC 1513 having a foamed structure, and this is adhering to the inner surface of the back side case part 1502 with a double-sided tape 1514. In the present embodiment, only the FPC 1513 has the foamed structure.

In the present embodiment, since the FPC 1513 has the foamed structure, the dielectric constant thereof is reduced.
Moreover, as a result of forming the antenna pattern 1511 on the surface of the FPC 1513 having a low dielectric constant, dielectric loss (tan δ) is reduced, highly efficient antenna characteristics are obtained,and wide-band characteristics are obtained. Moreover, as a result of disposing the low-dielectric-constant FPC 1513 between the back side case part 1502 and the antenna pattern 1511, the electrical distance between the outer surface of the back side case part 1502 and the antenna pattern 1511 becomes long. As a result, even when an external object composed of a metal or a high dielectric body is disposed outside of the back side case part 1502, the influence exerted on the antenna pattern 1511 can be reduced.

### (Sixteenth Embodiment)

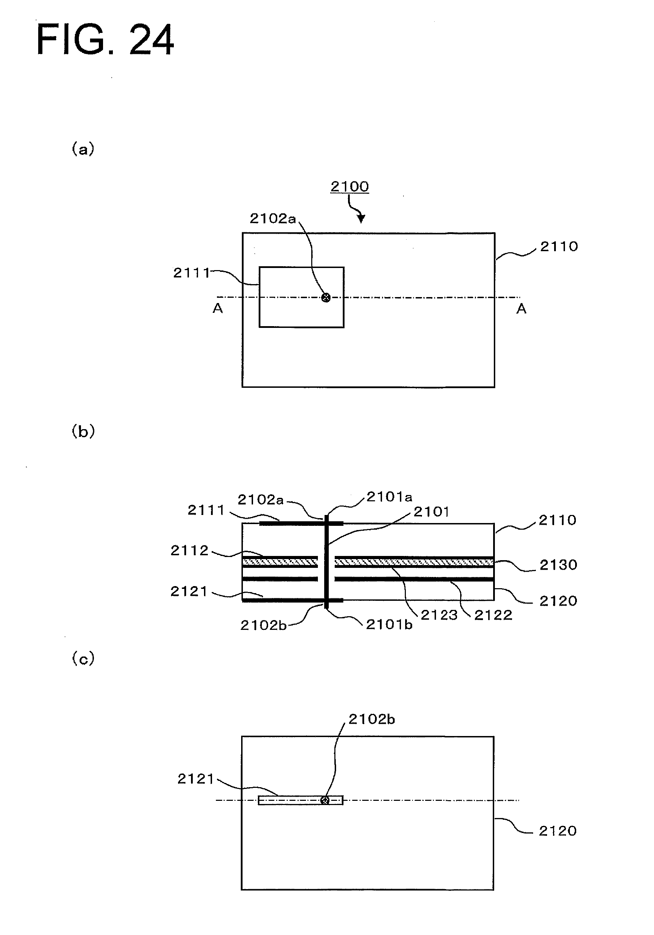

The antenna device according to the sixteenth embodiment of the present invention will be explained below by using Figure 24. Figure 24 shows a top view ((a) of this drawing), a cross-sectional view ((b) of this drawing), and a bottom view ((c) of this drawing) showing a configuration of the antenna device of the present embodiment. Figure 24 (b) is a cross-sectional view at a line AA shown in (a) and (c) of this drawing.

The antenna device 2100 of the present embodiment is provided with an antenna board 2110 and a feed board 2120, and both of them are integrally joined by a joining layer 2130. As shown in Figure 24, in the antenna device 2100, the antenna board 2110 is placed on and joined with the feed board 2120 with the joining layer 2130 interposed therebetween. Therefore, the plan view of (a) of this drawing shows the upper surface of the antenna board 2110, and the bottom view of (c) of this drawing shows the bottom surface of the feed board 2120.

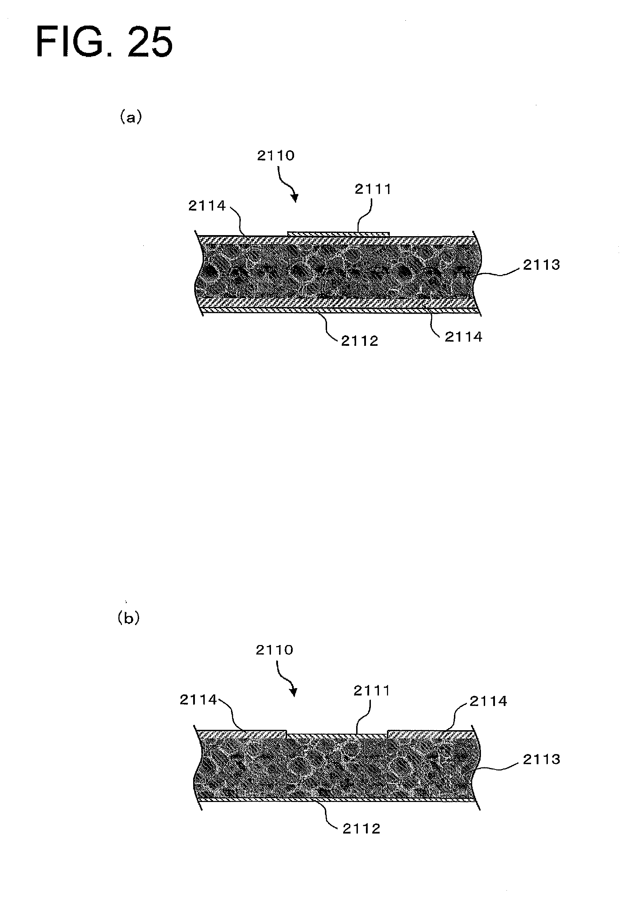

An antenna pattern 2111 of a microstrip patch type is formed on the upper surface of the antenna board 2110, and a first ground 2112 composed of a conductor layer is formed on the bottom surface thereof. In the present embodiment, the antenna board 2110 is formed by using a foamed dielectric resin in order to reduce the dielectric constant thereof. Examples of the foamed resin which is applicable to the antenna board 2110 are shown in Figure 25. Herein, the cross-sectional views of the antenna board 2110 of the cases in which the conductor layer is manufactured by two methods are shown.

In the antenna board 2110 shown in Figure 25 (a), conductor layers are formed by a method of vapor deposition. The interior of the antenna board 2110 is formed of a foamed part 2113 having a foamed structure, and skin layers 2114 are formed on outer layers thereof. The conductor layers such as the antenna pattern 2111 and the first ground 2112 are formed by directly vapor-depositing (vacuum vapor deposition) copper foil on the skin layers 2114. When the interior of the antenna board 2110 has such a foamed structure, the specific inductive capacity thereof can be caused to be 2 or less.

In the antenna board 2110 shown in Figure 25 (b), conductor layers are formed by electroless plating. In this case, the skin layer 2114 at the position where the conductor layer is to be formed is removed by, for example, laser irradiation, and the conductor layer is formed at that position by electroless plating. Since the foamed part 2113 has the anchor effect that causes a metal to adhere thereto, by utilizing it, the conductor layers such as the antenna pattern 2111 and the first ground 2112 are brought into close contact with the foamed part 2113.

On the other hand, on the feed board 2120, conductor layers 2122 and 2123 are formed in the interior and on the upper surface of the board, and a feed line 2121 is formed on the bottom surface thereof. In the present embodiment, the conductor layer 2122 formed in the interior of the feed board 2120 serves as a second ground. A general FR-4 can be used as a board material used in the feed board 2120.

The antenna board 2110 and the feed board 2120 are joined to each other by the joining layer 2130, which is using a tacky producer or an adhesive agent, by the surface of the antenna board 2110 on which the first ground 2112 is formed and the surface of the feed board 2120 on which the conductor layer 2123 is formed. Since the antenna board 2110 is formed of the foamed dielectric resin, sufficient rigidity cannot be ensured in some cases. Therefore, the rigidity of the antenna board 2110 is compensated for by using a board material, which has sufficient rigidity, for the feed board 2120 and joining the antenna board 2110 therewith.

Only by joining the antenna board 2110 and the feed board 2120 by the joining layer 2130 in the above described manner, the antenna pattern 2111 and the transmission line 2121 cannot be electrically connected to each other. Therefore, in the present embodiment, both of them are connected to each other by using a metal pin (metal-made connecting part) 2101. The metal pin 2101 penetrates through the antenna board 2110 and the feed board 2120, a first end 2101a thereof is connected to the antenna pattern 2111 by soldering by solder 2102a, and a second end 2101b is connected to the feed line 2121 by soldering by solder 2102b.

As described above, in the present embodiment, the antenna pattern 2111 and the first end 2101a of the metal pin 2101 have to be soldered on the antenna board 2110. Therefore, a foamed dielectric resin that has heat resistance and is not melted at least in soldering has to be used in the antenna board 2110 so that soldering can be carried out on the antenna board 2110. As a foamed dielectric resin having such heat resistance, foamed PPS which is foamed PPS (polyphenylene sulfide resin) can be used. Alternatively, foamed LCP which is foamed LCP (liquid crystal polymer) may be used.

The thickness of the antenna board 2110 is normally about 0.2 mm to 3 mm, and the metal pin 2101 is caused to penetrate therethrough. Therefore, it is preferred that the size of foaming of the foamed part 2113 be not so large. It is preferred that the particle size of the part of the foamed part 2113 foamed and containing a gas be 10 µm or less. As the foamed dielectric resin having such a foamed structure, MC (microcellular)-PPS manufactured by immersing PPS in a high-pressure carbon-dioxide gas can be used. The antenna board 2110 of the present embodiment is formed by using MC-PPS.

On the other hand, another board material having high rigidity is used in the feed board 2120. In the present embodiment, a penetrating hole through which the metal pin 2101 is to penetrate is formed in the feed board 2120; therefore, as the rigidity of the feed board 2120, the board has to have cutting resistance so that, at least, the board is not cleaved from the penetrating hole or the board is not cleaved when mechanical force is applied. FR-4 can be used as such a board material.

In the antenna device 2100 of the present embodiment, the antenna board 2110 formed of MC-PPS and the feed board 2120 formed of, for example, FR-4 are joined by the joining layer 2130. Normally, it is difficult to join PPS by a tacky producer or an adhesive agent. However, in the antenna board 2110 of the present embodiment, the metal first ground 2112 is formed on the bottom surface to be joined with the joining layer 2130; therefore, the first ground 2112 can be easily joined with the joining layer 2130. The upper surface of the feed board 2120 or the conductor layer 2123 formed on the upper surface can be easily joined with the joining layer 2130. Therefore, the antenna board 2110 and the feed board 2120 can be easily joined with each other by the joining layer 2130.

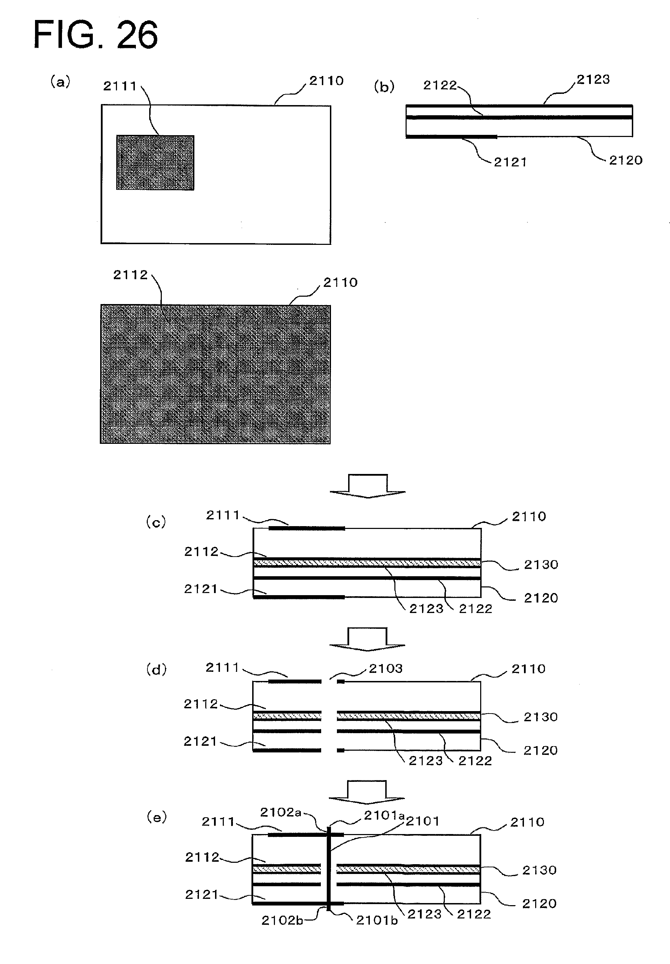

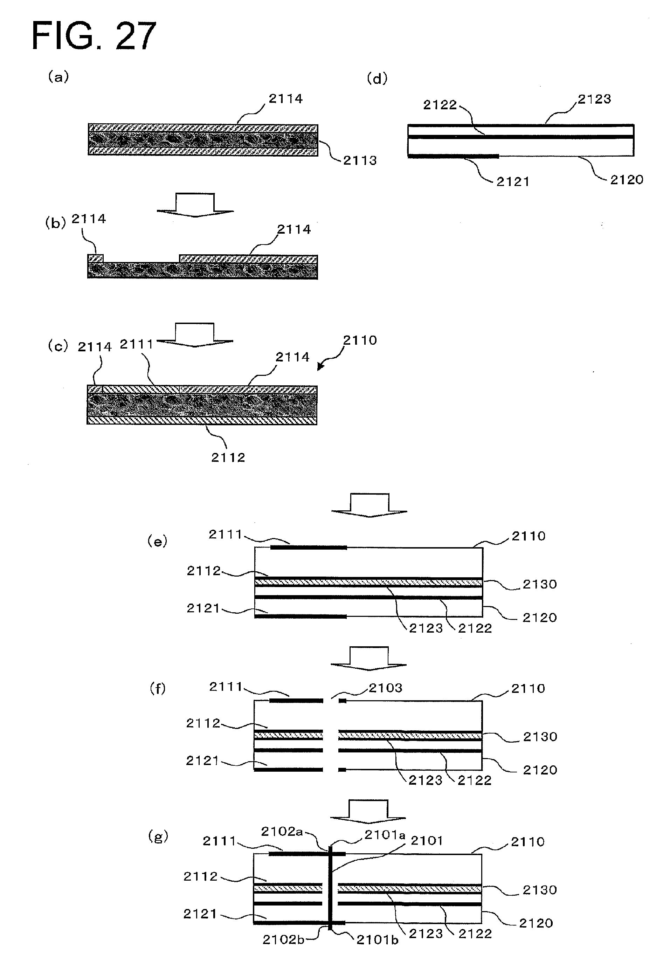

Next, an outline of a manufacturing method of the antenna device 2100 of the present embodiment will be explained below by using Figures 26 and 27. Figure 26 shows step views explaining the manufacturing method of the antenna device 2100, in which the conductor layers of the antenna board 2110 are formed by vapor deposition; and Figure 27 shows step views explaining a manufacturing method of the antenna device 2100, in which the conductor layers of the antenna board 2110 are formed by laser irradiation and electroless plating.

In the method of vapor deposition shown in Figure 26, the conductor layers are formed by directly vapor-depositing (vacuum vapor deposition) copper foil on both surfaces of MC-PPS, which is a board material of the antenna board 2110. Alternatively, aluminum may be used instead of copper. If the thickness of the conductor layers formed by the vapor deposition is not sufficient, the conductor layers may be grown by further plating copper thereon. Then, both of the surfaces are subjected to etching treatment to form predetermined patterns thereon, respectively. As a result, in the antenna board 2110, the antenna pattern 2111 as shown in the upper drawing of Figure 26 (a) is formed on the upper surface, and the first ground 2112 as shown in the lower drawing of Figure 26 (a) is formed on the bottom surface.

Regarding the feed board 2120, as shown in Figure 26 (b), the feed line 2121, the second ground 2122, and the conductor layer 2123 are formed by a conventional method by using FR-4 as a board material.

Then, the bottom surface of the antenna board 2110 and the upper surface of the feed board 2120 are joined by the joining layer 2130, which is composed of a tacky producer or an adhesive agent (Figure 26 (c)). Then, a penetrating hole 2103 penetrating through the antenna board 2110, the joining layer 2130, and the feed board 2120 is formed at a position perpendicularly passing through the antenna pattern 2111 and the feed line 2121 (Figure 26 (d)). Furthermore, the metal pin 2101 is caused to penetrate through the penetrating hole 2103, the first end 2101a of the metal pin 2101 and the antenna pattern 2111 are soldered by the solder 2102a, and the second end 2101b of the metal pin 2101 and the feed line 2121 are soldered by the solder 2102b (Figure 26 (e)). The first ground 2112 of the antenna board 2110 and the second ground of the feed board 2120 can be electrically connected by, for example, soldering at lateral surfaces of the boards.

In the method shown in Figure 27 using laser irradiation and electroless plating, with respect to MC-PPS which is the board material of the antenna board 2110 shown in Figure 27 (a), the skin layers 2114 are removed by irradiating with laser the positions at which the conductor layers of both surfaces are to be formed (Figure 27 (b)). Then, the conductor layers are formed on the both surfaces of the board by electroless plating (Figure 27 (c)). The foamed part 2113 is exposed from the positions from which the skin layers 2114 have been removed, and, by the anchor effect of the foamed part 2113, the conductor layers are formed only at the positions from which the skin layers 2114 have been removed. As a result, the antenna pattern 2111 is formed on the upper surface of the antenna board 2110, and the first ground 2112 is formed on the bottom surface thereof.

Below steps are similar to those shown in Figure 26 (b) to (e). In Figure 27 (d), the feed board 2120 having the feed line 2121, the second ground 2122, and the conductor layer 2123 is formed. Then, the bottom surface of the antenna board 2110 and the upper surface of the feed board 2120 are joined by the joining layer 2130 (Figure 27 (e)); the penetrating hole 2103 penetrating through the antenna board 2110, the joining layer 2130, and the feed board 2120 is formed (Figure 27 (f)); and the metal pin 2101 is caused to penetrate through the penetrating hole 2103 and soldered (Figure 27 (g)). As a result, the antenna device 2100 of the present embodiment is manufactured.

As explained above, in the present embodiment, each of the thicknesses of the boards is configured to be suitably selectable by separating the board of the antenna device 2100 into the antenna board 2110, on which the antenna pattern is formed, and the feed board 2120, on which the feed line is formed. As a result of forming the antenna board 2110 by using, for example, MC-PPS which is a foamed dielectric resin, the antenna board which has low dielectric loss, is highly efficient, and has wide-band characteristics is obtained. Moreover, as a result of joining the antenna board 2110 with the feed board 2120, which has sufficient rigidity, the rigidity of the antenna board 2110 can be enhanced. Furthermore, as a result of using the metal pin 2101, the antenna pattern 2111 and the feed line 2121 can be easily electrically connected to each other.

### (Seventeenth Embodiment)

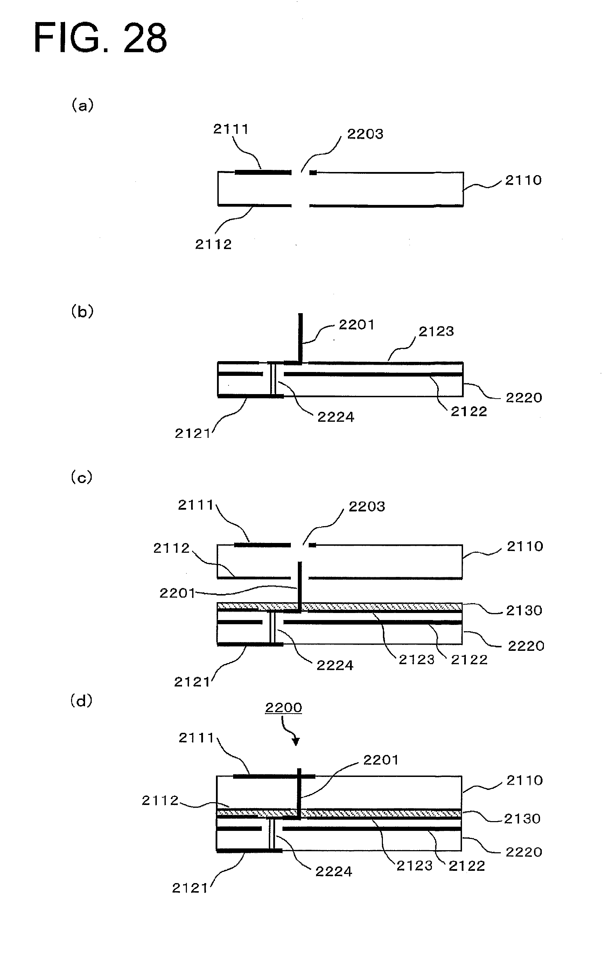

The antenna device according to the seventeenth embodiment of the present invention will be explained below by using Figure 28. Figure 28 shows cross-sectional views showing configurations of the antenna device 2200 of the present embodiment, and the cross-sectional views are taken at the line AA perpendicularly passing through the antenna pattern 2111 and the feed line 2121 shown in Figure 24.

In the antenna device 2200 of the present embodiment, the structure that electrically connects the antenna pattern 2111 formed on the upper surface of the antenna board 2110 and the feed line 2121 formed on the bottom surface of a feed board 2220 is different from that of the antenna device 2100 of the sixteenth embodiment. As well as the sixteenth embodiment, the antenna board 2110 of the present embodiment can be prepared by forming conductor layers by a method of vapor deposition or a method of laser irradiation and electroless plating. As shown in Figure 28 (a), a penetrating hole 2203 is formed in the antenna board 2110 of the present embodiment before joining with the feed board 2220.

As shown in Figure 28 (b), a metal pin 2201 is surface-mounted on the upper surface of the feed board 2220 of the present embodiment in advance. The metal pin 2201 is mounted so that a first end projects approximately perpendicularly from the upper surface of the feed board 2220, and a second end is connected to a through hole 2224, which is penetrating through the feed board 2220, by, for example, soldering. Therefore, the metal pin 2201 is electrically connected to the feed line 2121 via the through hole 2224.

By using the antenna board 2110 and the feed board 2220 configured in the above described manner, the antenna device 2200 of the present embodiment is prepared in a below manner. First, a tacky producer or an adhesive agent for forming the adhesive layer 2130 is applied between the antenna board 2110 and the feed board 2220, and the projecting part of the metal pin 2201 is inserted in the penetrating hole 2203 to overlap the antenna board 2110 with the feed board 2220 (Figure 28 (c)). Then, the first end of the metal pin 2201 is connected by soldering with the antenna pattern 2111 (Figure 28 (d)). As a result, the antenna pattern 2111 and the feed line 2121 are electrically connected to each other via the metal pin 2201 and the through hole 2224.

In the antenna device 2200 of the present embodiment configured in the above described manner, in the step of preparing the feed board 2220, the through hole 2224 can be formed, and the metal pin 2201 can be surface-mounted. Therefore, the step of preparing the antenna device 2200 by joining with the antenna board 2110 only requires soldering between the first end of the metal pin 2201 and the antenna pattern 2111, and the work of soldering can be reduced by half.

### (Eighteenth Embodiment)

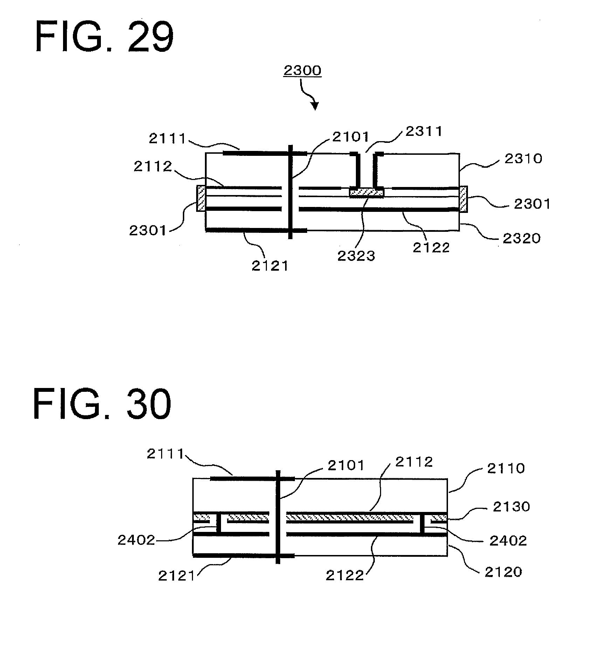

In the antenna devices 2100 and 2200 of the above described embodiments, the antenna board 2110 and the feed board 2120 or 2220 are joined by the joining layer 2130 using the tacky producer or the adhesive agent; however, if they can be joined by soldering instead of that, soldering may be used. Hereinafter, the antenna device 2300 of the eighteenth embodiment, in which the antenna board 2110 and the feed board 2120 are connected by soldering, will be explained by using Figure 29.

In the antenna device 2300 shown in Figure 29, a through hole 2311, in which the inner surface of a penetrating hole is plated, is formed in the antenna board 2310; on the other hand, a conductor layer 2323 is formed on the upper surface of the feed board 2320. Since the interior of the antenna board 2310 has a foamed structure as well as the above described embodiments, it is easy to plate the inner surface of the penetrating hole by the anchor effect to form the through hole 2311. In the present embodiment, the antenna board 2310 and the feed board 2320 are joined by soldering a bottom-surface-side end part of the through hole 2311 and the conductor layer 2323.

In the present embodiment, the through hole 2311 and the conductor layer 2323 are soldered, and the first ground 2112 formed on the antenna board 2310 and the second ground 2122 formed on the feed board 2320 are electrically connected to each other by soldering (solder 2301) on the lateral surfaces of the boards. In this manner, according to the present embodiment, the antenna board 2310 and the feed board 2320 can be joined only by soldering.

As further another method of joining the antenna board and the feed board, for example, a method that mechanically joins both of the boards by using, for example, screws is conceivable. In that case, the antenna board formed of the foamed dielectric resin has to have rigidity at a degree with which the board is not broken at least by screwing.

In the above described embodiments, the electrical connection between the first ground 2112 and the second ground 2122 is established by soldering at the lateral surfaces of the boards; however, instead of this, as shown as an example in Figure 30, the connection can be established by using a metal pin (metal connecting part) 2402. A first end of the metal pin 2402 is connected to the second ground 2122, and a second end thereof is projecting to the side of the surface joined with the antenna board 2110. The pin then penetrates through the joining layer 2130 and is electrically connected to the ground 2112 of the antenna board 2110. It goes without saying that, if operation is carried out without the electrical connection between the first ground 2112 and the second ground 2122, the connection is not required to be established.

### (Nineteenth Embodiment)

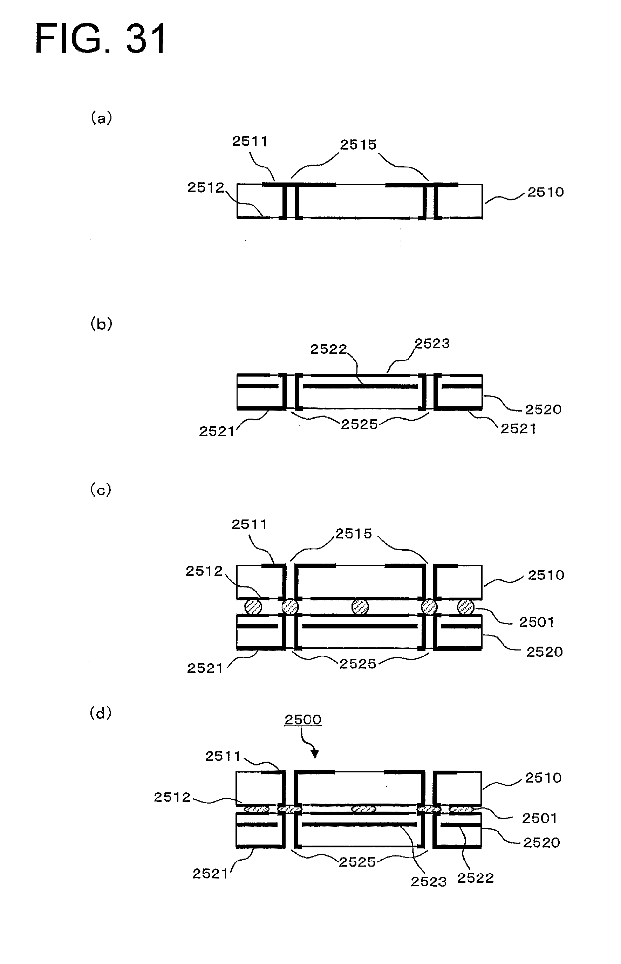

The antenna device according to the nineteenth embodiment of the present invention will be explained below by using Figure 31. Figure 31 shows cross-sectional views showing configurations of the antenna device 2500 of the present embodiment, and the cross sectional views are taken at the line AA perpendicularly passing the antenna pattern 2111 and the feed line 2121 shown in Figure 24.

The antenna device 2500 of the present embodiment is used in a high frequency band, and an antenna pattern 2511 is formed of, for example, a patch antenna having a size of about 1 to 2 mm. If the size of the antenna pattern 2511 is small like this, it is difficult to connect the antenna pattern 2511 to the metal pins used in the above described embodiments. Therefore, in the present embodiment, instead of the metal pins, through holes are used as a means that electrically connects the antenna pattern 2511 to the side of a feed board 2520.

The antenna board 2510 and the feed board 2520 of the present embodiment before joining are shown in Figures 28 (a) and (b), respectively. The antenna pattern 2511 formed on the upper surface of the antenna board 2510 is connected to through holes (first through holes) 2515 penetrating through the antenna board 2510. In the feed board 2220, different through holes (second through holes) 2525 are formed at positions opposed to the through holes 2515 of the antenna board 2510 side, and feed lines 2521 are connected thereto, respectively. The diameter of the through holes 2515 and 2525 can be, for example, 100 µm or less.

In the present embodiment, the antenna board 2510 and the feed board 2520 are joined by soldering. In order to solder the antenna board 2510 and the feed board 2520, as shown in Figure 31 (c), solder balls 2501 are disposed at predetermined positions between the antenna board 2510 and the feed board 2520. As the solder balls 2501, for example, those having a diameter of about 100 to 200 µm can be used. In order to electrically connect the through holes 2515 of the antenna board 2510 side and the through holes 2525 of the feed board 2520 side to each other, the solder balls 2501 are disposed at least at the joining parts of the through holes 2515 and the through holes 2525. In the case in which the first ground 2512 of the antenna board 2510 side and the second ground 2522 of the feed board 2520 side are to be electrically connected to each other, the solder balls 2501 are disposed also at the positions at which they can be electrically connected.

As described above, when the solder balls 2501 are disposed at appropriate positions between the bottom surface of the antenna board 2510 and the upper surface of the feed board 2520, the solder balls 2501 are then melted by reflow (Figure 31 (d)). As a result, the through holes 2515 and the through holes 2525 are electrically connected. Moreover, the antenna board 2510 and the feed board 2520 are mechanically connected by soldering. According to the present embodiment, as a result of : using the foamed dielectric resin in the antenna board 2510, connecting the antenna pattern 2511 and the feed lines 2521 by the through holes 2515 and 2525, and connecting the antenna board 2510 and the feed board 2520 by soldering; the antenna device 2500 which has low dielectric loss, is highly efficient, and has wide-band characteristics can be provided.

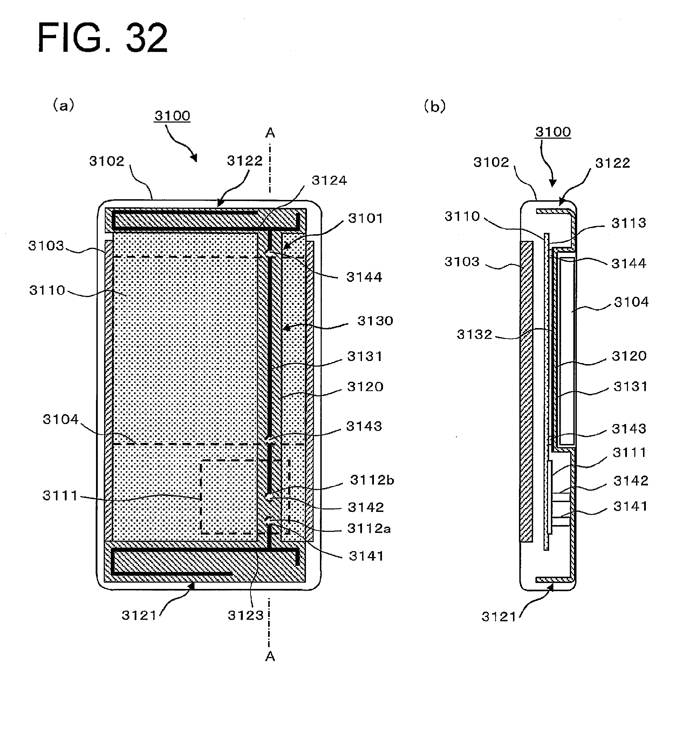

The wireless communication device according to the twentieth embodiment of the present invention will be explained by using Figure 32. Figure 32 (a) is a bottom view showing a configuration of the wireless communication device 3100 of the twentieth embodiment, and Figure 32 (b) is a cross-sectional view at a line A-A shown in (a) of this drawing. The wireless communication device 3100 is provided with: a circuit board 3110 equipped with a high-frequency circuit part 3111 having a wireless communication function; a low-loss base material 3120 equipped with two antenna parts 3121 and 3122; a battery 3104, which supplies necessary electric power; a chassis 3102, which houses them; and adisplaypart (for example, LCD) 3103, which carries out, for example, display for a user. The bottom view shown in Figure 32 (a) is showing the wireless communication device 3100 from the battery 3104 side, wherein the back surface of the chassis 3102 and the battery 3104 are excluded.

The antenna parts 3121 and 3122 have antenna radiation conductor parts 3123 and 3124, respectively, formed at both end parts of the low-loss base material 3120. The antenna radiation conductor parts 3123 and 3124 can be formed by using copper foil laminating, plating, or vapor deposition on one surface or both surfaces of the low-loss base material 3120.

The wireless communication device 3100 of the present embodiment is equipped with the two antenna parts 3121 and 3122, which operate at least in the same received frequency band, and can be applied to, for example, a smartphone or a PC which carries out MIMO operations. In order to carry out MIMO operations, it is preferred that the distance between the two antenna parts 3121 and 3122 be increased to maintain a low correlation. Therefore, in the wireless communication device 3100, the antenna parts 3121 and 3122 are disposed at longitudinal-direction both end parts of the chassis 3102, the length of the low-loss base material 3120 is caused to be approximately equal to the longitudinal-direction length of the chassis 3102, and the antenna radiation conductor parts 3123 and 3124 are formed at the both end parts thereof, respectively.

Both of the antenna parts 3121 and 3122 are operated when connected to respective input/output parts 3112a and 3112b of the high-frequency circuit part 3111. The two input/output parts 3112a and 3112b are disposed to be close to each other. Therefore, if the two antenna parts 3121 and 3122 are disposed to be away from each other, at least one of them is disposed at a position away from the input/output part 3112a or 3112b. Therefore, transmission lines for connecting the antenna part 3121 or 3122, which is disposed at a distant position, with the input/output part 3112a or 3112b is required.

In the present embodiment, the antenna part 3122 is disposed at a position away from the input/output part 3112b of the high-frequency circuit part 3111, and the part between the antenna radiation conductor part 3124 of the antenna part 3122 and the input/output part 3112b of the high-frequency circuit part 3111 is connected by a transmission line part 3130. The transmission line part 3130 is formed on the low-loss base material 3120 as well as the antenna parts 3121 and 3122, and the antenna parts 3121 and 3122 and the transmission line part 3130 are integrated to form a transmission-line integrated antenna 3101. The transmission line part 3130 connected to the antenna radiation conductor part 3124 is connected to the input/output part 3112b.

The transmission line part 3130 has a signal line 3131 patterned on a first-side surface of the low-loss base material 3120, and a ground pattern 3132 is formed on a second-side surface of the low-loss base material 3120. The signal line 3131 and the ground pattern 3132 are away from each other by the distance corresponding to the thickness of the low-loss base material 3120, and a microstrip line is formed by the combination thereof. The thickness of the low-loss base material 3120 is preferred to be at least 0.2 mm. If the antenna radiation conductor parts 3123 and 3124 are formed also on the same surface as that of the ground pattern 3132, a ground pattern 132 is formed in a region excluding the region in which the antenna radiation conductor parts 3123 and 3124 are formed.

It is preferred that the low-loss material 3120 have flexibility. Byvirtueofthat, the low-lossmaterial 3120 equipped with the antenna parts 3121 and 3122 and the transmission line part 3130 can be deformed along the shape of the chassis 3102, and the transmission-line integrated antenna 3101 can be easily mounted in small space in the chassis 3102. In this process, the transmission-line integrated antenna 3101 may be fixed to the inner side of the chassis 3102 by, for example, a bonding tape or thermal welding. It is preferred that a material having a dielectric tangent of 0.01 or less be used as the low-loss material 3120 like this. For example, a resin foam containing independent bubbles in the interior thereof can be used. It is preferred that the resin foam be composed of bubbles having a foaming diameter of 20 µm or less. If the resin foam is used as the low-loss material 3120, the antenna radiation conductor parts 3123 and 3124, the signal line 3131, and the ground pattern 3132 can be formed by electroless plating.
Moreover, by further carrying out electrolytic plating after carrying out the electroless plating, the thicknesses of the conductor layers of the radiation conductor parts 3123 and 3124, the signal line 3131, and the ground pattern 3132 can be increased.

In the present embodiment, the antenna parts 3121 and 3122 and the transmission-line part 3130 can be integrally mounted by housing the transmission-line integrated antenna 3101 at a predetermined position in the chassis 3102. Elastic members 3141 and 3142 are provided in the high-frequency circuit part 3111 side and the low-loss base material 3120 side, respectively, so that, when the transmission-line integrated antenna 3101 is disposed at the predetermined position in the chassis 3102, the antenna radiation conductor part 3123 of the antenna part 3121 is connected to the input/output part 3112a and that the end part of the signal line 3131 of the transmission line part 3130 in the opposite side of the end part to which the antenna part 3122 is connected is connected to the input/output part 3112b.

Elastic members 3143 and 3144 are provided in the vicinities of the both ends of the transmission line part 3130, respectively, so that the ground pattern 3132 formed on the second-side surface of the low-loss base material 3120 is connected to a ground pattern 3113 of the circuit board 3110, which is a main ground plane of the wireless communication device 3100. Each of the elastic members 3143 and 3144 is provided in the high-frequency circuit part 3111 side or the low-loss base material 3120 side. In this manner, the ground pattern 3132 and the ground pattern 3113 are configured to be connected to each other in the vicinities of the both ends of the transmission line part 3130 by providing the elastic members 3143 and 3144; as a result, a microstrip line having low transmission loss can be formed for the transmission line part 3130 having a long distance.

In the wireless communication device 3100 of the present embodiment, even if the distance between the antenna radiation conductor part 3124 and the input/output part 3112b of the high-frequency circuit part 3111 is, for example, equal to or more than 50 mm corresponding to about the half of the longitudinal-direction length of the chassis 3102, the low-loss transmission line part 3130 of which transmission loss is 0.2 dB or less at around 2.5 GHz can be realized.

When the elastic members 3141 to 3144 as described above are provided, only by mounting the transmission-line integrated antenna 3101, in which the antenna parts 3121 and 3122 and the transmission line part 3130 are integrated, at a predetermined position in the chassis 3102, the antenna parts 3121 and 3122 can be connected to the circuit board 3110, and the ground pattern 3132 can be connected to the main ground pattern 3113. In the present embodiment, the connection between the antenna radiation conductor part 3123 and the input/output part 3112a, the connection between the signal line 3131 and the input/output part 3112b, and the connection between the ground pattern 3113 and 3132 can be stably maintained by the elastic force of the elastic members 3141 to 3144. For example, springs can be used as the elastic members 3141 to 3144.

In the wireless communication device 3100 of the present embodiment, the signal line 3131 formed of a conductor pattern on the surface of the low-loss base material 3120 is used as the transmission line that connects the antenna part 3122 and the high-frequency circuit part 3111 to each other, and the antenna parts 3121 and 3122 and the transmission line part 3130 are integrated to form the transmission-line integrated antenna 3101; therefore, cost reduction can be realized by reducing the number of parts compared with a conventional wireless communication device using a coaxial cable.

The antenna parts 3121 and 3122 and the transmission line part 3130 can be formed by using FPC. However, since the FPC is normally composed of a dielectric body having a thickness of a base material of about 0. 05 µm, the line width of the signal line has to be extremely thin in order to constitute a transmission line of, for example, 50 Ω, and conductor loss in the signal line becomes notable. Moreover, the ground level thereof also becomes unstable; therefore, influence due to noise also becomes a problem. On the other hand, in the wireless communication device 3100 of the present embodiment, the thickness of the low-loss base material 3120 is 0.2 mm or more; therefore, a certain area or more can be ensured as the cross-sectional area of the signal line 3131, and generated conductor loss can be reduced. Moreover, influence of noise can be reduced by stabilizing the ground level.

When a microstrip line is to be formed on a circuit board as a transmission line, conventionally, a glass epoxy board (FR-4) which has good processability as a circuit board and has reduced cost has been used. However, a glass epoxy board has poor dielectric characteristics, and, if a transmission line having a long distance is formed by using this, dielectric loss becomes notable. On the other hand, in the wireless communication device of the present embodiment, the microstrip line is formed by using the low-loss base material such as the resin foam; therefore, dielectric loss can be significantly reduced.

### (Twenty-first Embodiment)

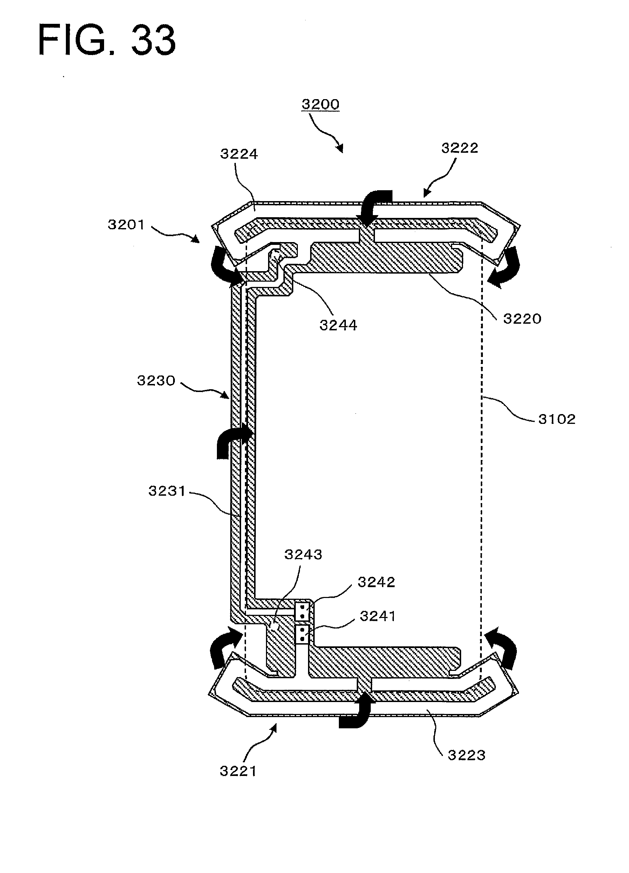

The wireless communication device according to the twenty-first embodiment of the present invention will be explained by using Figure 33. Figure 33 is a bottom view showing a partial configuration of the wireless communication device 3200 of the twenty-first embodiment. This drawing shows an expanded view of a transmission-line integrated antenna 3201 in which antenna parts 3221 and 3222 and a transmission line part 3230 are formed on and integrated with a low-loss base material 3220, and the chassis 3102 of the wireless communication device 3200, in which they are built in, is shown by a broken line. Also in the present embodiment, the low-loss base material 3220 has flexibility and is formed of, for example, a resin foam containing independent bubbles in the interior thereof.

As shown in Figure 33, the transmission-line integrated antenna 3201 of the present embodiment is formed to have a size protruding from the chassis 3102. More specifically, the part of the low-loss base material 3220 on which the antenna parts 3221 and 3222 are mounted is formed so as to protrude from the chassis 3102 in the top-bottom direction and the left-right direction of the drawing. Also, the part of the low-loss base material 3220 on which the transmission line part 3230 is mounted is formed so as to protrude from the chassis 3102 in either one of the left-right directions of the drawing (left direction in Figure 33). The protruding width of each of them is equal to or less than the thickness of the wireless communication device 3200.

As a result of forming the transmission-line integrated antenna 3201 in the above described manner, when it is to be housed in the chassis 3102, the low-loss base material 3220 can be bent by about 90 degrees in the thickness direction along a lateral surface of the chassis 3102 to be housed as shown by arrows in Figure 33. In order to house the transmission line part 3230 along the lateral surface of the chassis 3102, the widths of the low-loss base material and the ground pattern positioned at the transmission line part 3230 is preferred to be smaller than the thickness of the wireless communication device 3200 and is preferred to be 8 mm or less. By virtue of this, the antenna parts 3221 and 3222 and the transmission line part 3230 can be disposed in slight space provided along a wall surface of the chassis 3102. When the transmission line part 3230 is to be bent along the lateral surface of the chassis 3102, the ground pattern positioned at the transmission line part 3230 is preferred to be bent so as to face outside (the side facing the wall surface of the chassis 3102). By virtue of this, contamination of noise from outside into the signal line 3231 can be reduced. Moreover, upon usage, influence of a human hand part with respect to the transmission line can be reduced.

In the present embodiment, all of: elastic members 3241 and 3242, which connect antenna radiation conductor parts 3223 and 3224 of the antenna parts 3221 and 3222 and an input/output part of an unshown high-frequency circuit part, and elastic members 3243 and 3244, which connect a ground pattern formed on a second-side surface of the low-loss base material 3220 and a ground pattern of the circuit board (both of these are not shown), are built in the chassis 3102.

### (Twenty-second Embodiment)

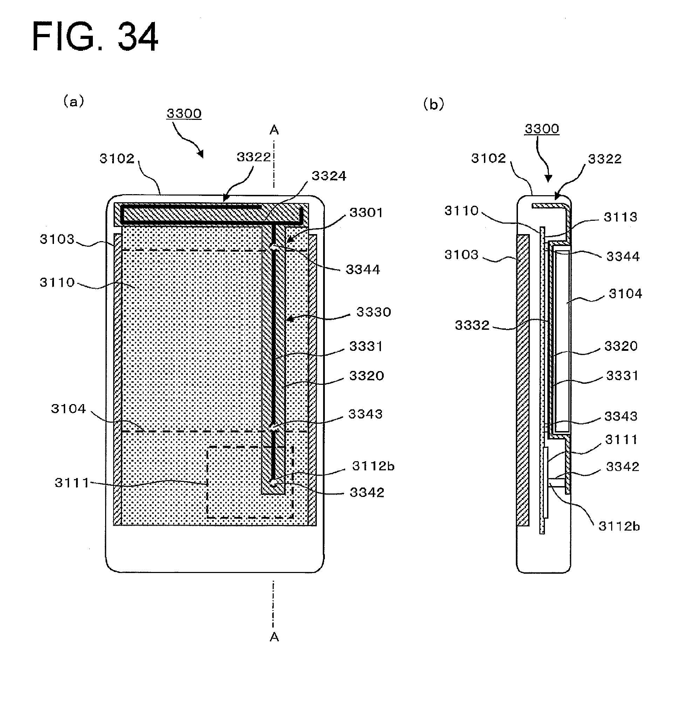

The wireless communication device according to the twenty-second embodiment of the present invention will be explained by using Figure 34. Figure 34 (a) shows a bottom view showing a configuration of a wireless communication device 3300 of the twenty-second embodiment, and Figure 34 (b) shows a cross-sectional view at a line A-A shown in (a) of this drawing. The bottom view shown in Figure 34 (a) shows the wireless communication device 3300 from the battery 3103 side, wherein the back surface of the chassis 3102 and the battery 3103 are excluded. In the wireless communication device 3300 of the present embodiment, a transmission-line integrated antenna 3301 is formed by mounting only one antenna part 3322 on a low-loss base material 3320.

Even in the case in which the number of the antenna (s) mounted on the wireless communication device is one, the transmission-line integrated antenna 3301 of the present embodiment can be used if the disposing position of the antenna is limited and the antenna has to be disposed at a position away from an input/output part of a high-frequency circuit. In the present embodiment, the antenna part 3322 disposed at a position away from the high-frequency circuit part 3111 is connected to the input/output part 3112b of the high-frequency circuit part 3111 by using a transmission line 3330. More specifically, an antenna radiation conductor part 3324 of the antenna part 3322 is connected to a first-side end part of a signal line 3331, and a second-side end part of the signal line 3331 is connected to the input/output part 3112b by an elastic member 3342. A ground pattern 3332 formed on a second-side surface of the low-loss base material 3320 is connected to the ground pattern 3113 of the circuit board 3110 by elastic members 3343 and 3344.

The transmission-line integrated antenna 3301 of the present embodiment is composed by using the antenna part 3322 and the low-loss base material 3320 having a size corresponding to the transmission line part 3330 of the section from the antenna part 3322 to the input/output part 3112b. In this manner, in the wireless communication device of the present invention, the transmission-line integrated antenna can be prepared by appropriately determining the size and the shape of the low-loss base material in accordance with the number of the antenna (s) and forming the antenna radiation conductor part, the signal line, and the ground pattern. The prepared transmission-line integrated antenna can be connected to the input/output part of the high-frequency circuit and the ground pattern, which is a main ground pane of the wireless communication device, by using the elastic members.

### (Twenty-third Embodiment)

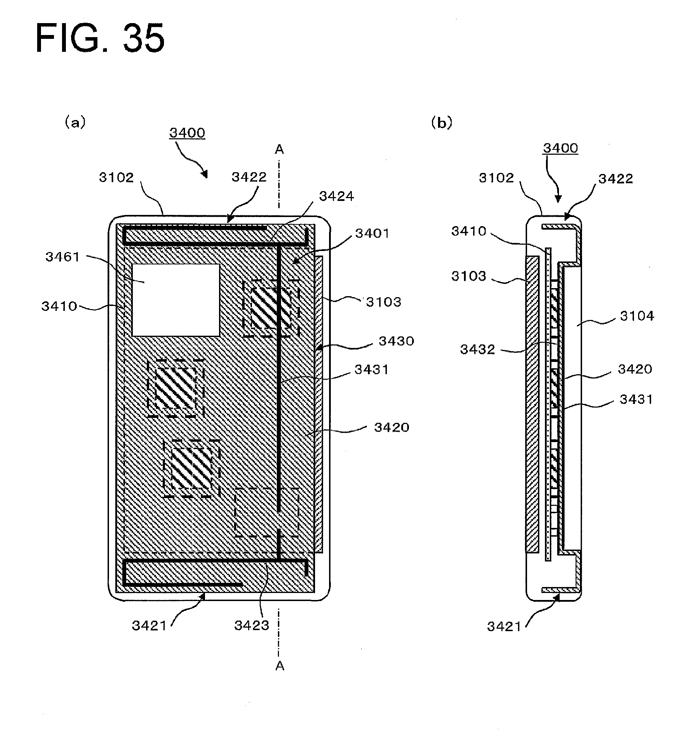

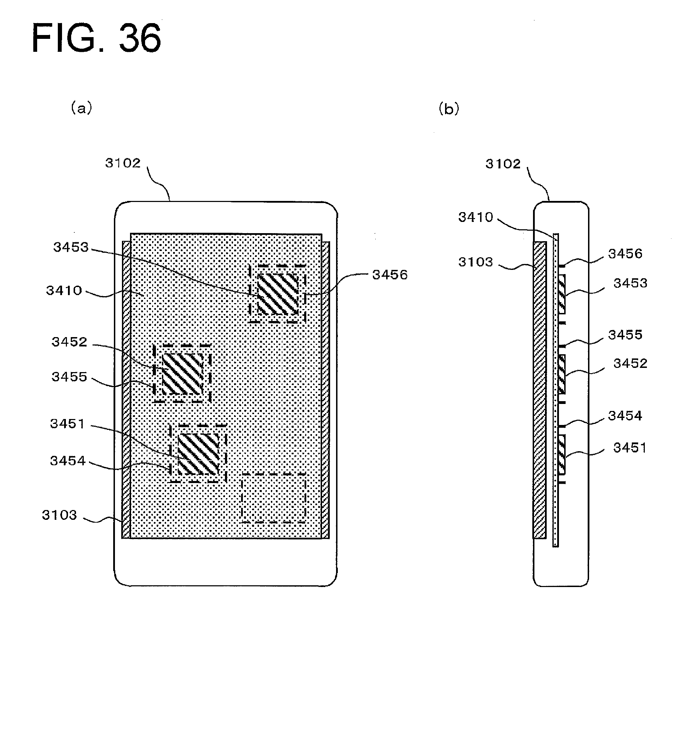

The wireless communication device according to the twenty-third embodiment of the present invention will be explained by using Figures 35 and 36. Figure 35 shows a bottom view and a lateral view showing, from the battery side, the wireless communication device 3400 of the twenty-third embodiment in which a circuit board 3410 and a transmission-line integrated antenna 3401 having antenna parts 3421 and 3422 formed on a low-loss base material 3420 and a transmission line part 3430 are built. Figure 36 shows a bottom view and a lateral view of a conventional wireless communication device in which the transmission-line integrated antenna 3401 is not built.

In the present embodiment, the circuit board 3410 on which a plurality of circuit blocks 3451 to 3453 composed of IC, discrete parts, etc. as shown in Figure 36 are mounted is built in the wireless communication device 3400. In the circuit board 3410 like this, in order to electromagnetically separate the circuit blocks 3451 to 3453, metal frames 3454 to 3456 respectively surrounding them are provided. Conventionally, in order to enhance an electromagnetic shield effect, the metal frames 3454 to 3456 have been covered with predetermined metal covers, respectively. Since heat is released from each of the circuit blocks 3451 to 3453, it is preferred that the wireless communication device 3400 in which the circuit board 3410 is built be configured so that the released heat can be diffused and released to outside.

Therefore, in the present embodiment, as shown in Figure 35, the width of the transmission line part 3430 of the transmission-line integrated antenna 3401 has an equivalent size as the width of the circuit board 3410, and the metal frames 3454 to 3456 are configured to be covered with the transmission line part 3430 instead of the conventional metal covers. A ground pattern 3432 formed on the transmission line part 3430 is formed on the approximately entire surface in the width direction and has a width equivalent to that of the circuit board 3410. The ground pattern 3432 is directed toward the circuit board 3410 side and pushed against and placed on the metal frames 3454 to 3456. As a result, a shield effect similar to that of the conventional metal covers is obtained, and the heat released from the transmitting parts 3451 to 3453 is easily diffused on the surface of the ground pattern 3432 and released to outside.

In order to cause the heat to efficiently diffuse on the ground pattern 3432, the thickness of the ground pattern 3432 is preferred to be 100 µm or more.

Moreover, the heat is easily propagated also to the signal line 3431 of the transmission line 3430 and released to outside. In order to further efficiently carry out diffusion of the heat, a heat diffusing pattern 3461 made of metal may be further provided on a first-side surface of the low-loss base material 3420, which is away from the signal line 3431 by a predetermined distance or more. The heat diffusing pattern 3461 is preferred to be away from the signal line 3431 by 200 µm or more. When the heat diffusing pattern 3461 is connected to the ground pattern 3432 by a through hole, the heat absorbed by the ground pattern 3432 is transmitted to the heat diffusing pattern 3461 via the through hole and is dissipated from the heat diffusing pattern 3461 to outside, and the effect of heat dissipation can be further enhanced. Furthermore, when the transmission-line integrated antenna 3401 of the present embodiment is mounted, the heat dissipation from the battery 3104 can be also configured to be diffused and released to outside.

In the present embodiment, the width of the transmission line part 3430 is equivalent to that of the circuit board 3410 so as to cover and be placed on the circuit board 3410, and the conventionally-used metal covers to be placed on the metal frames 3454 to 3456 are not necessary; therefore, there is no risk that the low-loss base material 3420 cannot be mounted due to limitation caused by the thickness of the chassis 3102. The low-loss base material 3420 has flexibility; therefore, the low-loss base material 3420 can absorb variations in the height of the circuit blocks 3451 to 3453 and the metal frames 3454 to 3456 to be in close contact therewith. Therefore, the shield effect and the heat dissipating effect can be enhanced.

The transmission-line integrated antenna 3401 of the present embodiment serves as one large board. Therefore, the antenna characteristics can be improved and unnecessary radiation caused by the ground pattern 3432 can be reduced by constituting a matching circuit part thereon by a distribution constant or changing the shape of the ground pattern 3432.

The description in the present embodiment shows examples of the printed circuit boards, the antennas, the wireless communication devices, and the manufacturing methods thereof according to the present embodiment, and the present invention is not limited thereto. The detailed configurations, detailed operations, etc. of the printed circuit boards, the antennas, the wireless communication devices, and the manufacturing methods thereof of the present embodiments can be arbitrarily changed within a range not departing from the gist of the present invention.

### Reference Signs List

50 COAXIAL CABLE
100, 200, 300, 501, 502, 600, 700, 800 PRINTED CIRCUIT BOARD
101, 601 RESIN MATERIAL
102, 402, 602 FOAMED RESIN MATERIAL
103 PATTERNED FOAMED RESIN MATERIAL
111, 411, 503, 611 SKIN LAYER
112, 412, 612, 712, 812, 912 FOAMED PART
120, 420, 620, 714, 922 CONDUCTOR LAYER
201, 301 PENETRATING HOLE
400, 500 ANTENNA
511 ANTENNA PATTERN
512, 521 GND PATTERN
513 MATCHING CIRCUIT PART
514, 531, 532 PAD
520 CABLE HOLDER PART
532 MATCHING CIRCUIT AREA
711 RESIN LAYER
713 CATALYST
811 COPPER FOIL
813 HOT-MELT ADHESIVE AGENT
901 FOAMED RESIN MATERIAL
902 SKIN LAYER
921 MELT LAYER
1100, 1200, 1300, 1400, 1500 ANTENNA DEVICE
1101 FRONT SIDE CASE PART (FIRST CASE PART)
1102, 1502 BACK SIDE CASE PART (SECOND CASE PART)
1103 CONTROL BOARD
1104 FEED TERMINAL
1105 TERMINAL HOLDING PART
1106 RECESSED PART
1107 WELDING BOSS
1111, 1211, 1311, 1411, 1511 ANTENNA PATTERN
1112, 1212, 1312, 1412 FOAMED LAYER
1213, 1413, 1513 FPC
1214, 1414, 1514 DOUBLE-SIDED TAPE
2100, 2200, 2300, 2500 ANTENNA DEVICE
2101, 2201, 2402 METAL PIN
2102a, 2102b, 2301 SOLDER
2103, 2203 PENETRATING HOLE
2110, 2310, 2510 ANTENNA BOARD
2111, 2511 ANTENNA PATTERN
2112, 2512 FIRST GROUND
2113 FOAMED PART
2114 SKIN LAYER
2120, 2220, 2320, 2520 FEED BOARD
2121, 2521 FEED LINE
2122, 2522 SECOND GROUND
2123, 2323, 2523 CONDUCTOR LAYER
2130 JOINING LAYER
2224, 2311, 2515, 2525 THROUGH HOLE
2501 SOLDER BALL
3100, 3200, 3300 WIRELESS COMMUNICATION DEVICE
3101, 3201, 3301, 3401 TRANSMISSION-LINE INTEGRATED ANTENNA
3102 CHASSIS
3103 LCD
3104 BATTERY
3110, 3410 CIRCUIT BOARD
3111 HIGH-FREQUENCY CIRCUIT PART
3112a, 3112b INPUT/OUTPUT UNIT
3113, 3132, 3332, 3432 GROUND PATTERN
3120, 3220, 3320, 3420 LOW-LOSS BASE MATERIAL
3121, 3122, 3221, 3222, 3321 ANTENNA PART
3123, 3124, 3223, 3224, 3323 ANTENNA RADIATION CONDUCTOR PART
3130, 3230, 3330, 3430 TRANSMISSION LINE PART
3131, 3231, 3331, 3431 SIGNAL LINE
3141 TO 3144, 3241 TO 3244, 3341, 3343, 3344 ELASTIC MEMBER
3451 TO 3453 CIRCUIT BLOCK
3454 TO 3456 METAL FRAME
3461 HEAT DIFFUSING PATTERN

## Claims

1. A manufacturing method of a printed circuit board comprising:
a foaming step of forming a foamed part having a foamed structure in at least part of its interior by subjecting a predetermined resin to a foaming process and forming a non-foamed skin layer on an outer surface of the foamed part;
a skin-layer removing step of removing part of the skin layer in a predetermined pattern shape and exposing the foamed part; and
a conductor-layer forming step of forming a conductor layer on the exposed foamed part by electroless plating or vapor deposition.

2. The manufacturing method of the printed circuit board according to claim 1, wherein
the foaming step is carried out after the resin is injection-molded into a predetermined shape.

3. The manufacturing method of the printed circuit board according to claim 1, wherein
the foaming step is carried out at the same time as injection molding of pellets of the predetermined resin into which a predetermined gas has been permeated.

4. The manufacturing method of the printed circuit board according to any one of claims 1 to 3, wherein
the foamed part is exposed by melting the part of the skin layer by laser irradiation in the skin-layer removing step.

5. The manufacturing method of the printed circuit board according to any one of claims 1 to 3, wherein
the foamed part is exposed by mechanically removing the part of the skin layer in the skin-layer removing step.

6. The manufacturing method of the printed circuit board according to any one of claims 1 to 5, wherein
the resin is PPS.

7. The manufacturing method of the printed circuit board according to any one of claims 1 to 6, wherein
the foamed part comprises bubbles having a foaming diameter of 10 µm or less.

8. The manufacturing method of the printed circuit board according to any one of claims 1 to 7, wherein
the foamed part has a specific inductive capacity of 2 or less.

9. A printed circuit board formed by using a predetermined resin, the printed circuit board comprising:
a foamed part having a foamed structure formed in at least part of an interior of the resin;
a skin layer formed on an outer surface of the foamed part and having no foamed structure; and
a conductor layer in close contact with a surface of the foamed part from which the skin layer has been removed.

10. The printed circuit board according to claim 9, further comprising
a penetrating hole penetrating through the conductor layer formed on the surface of the resin in a first side, the skin layer formed on the surface thereof in a second side, and the foamed part.

11. The printed circuit board according to claim 9 or 10, further comprising
two said conductor layers formed on opposing surfaces of the resin, respectively, and a through hole penetrating through the foamed part and having a conductor layer on its inner surface so as to electrically connect the two conductor layers.

12. An antenna formed by using a predetermined resin, the antenna comprising:
a foamed part having a foamed structure formed in at least part of an interior of the resin;
a skin layer formed on an outer surface of the foamed part and having no foamed structure; and
a conductor layer in close contact with a surface of the foamed part from which the skin layer has been removed in a predetermined antenna pattern shape; wherein
the conductor layer operates as an antenna element.

13. The antenna according to claim 12, further comprising
a cable holder part formed so that part of the resin is in close contact with a sheath of a RF cable, wherein
the conductor layer is formed at the position of the cable holder part in close contact with the sheath, and
the sheath and the conductor layer are soldered with each other.

14. An antenna device comprising:
a case part;
an antenna pattern fixed to an inner surface side of the case part; and
a foamed layer having a foamed structure and disposed between the antenna pattern and the inner surface of the case part.

15. The antenna device according to claim 14, wherein
a recessed part having a predetermined depth is formed on the inner surface of the case part; and
the foamed layer is disposed in an interior of the recessed part.

16. The antenna device according to claim 15, wherein
the antenna pattern is formed on a surface of the foamed layer.

17. The antenna device according to claim 15, wherein
the antenna pattern is formed on a first-side surface of a predetermined antenna board, and a second-side surface of the antenna board is placed on the foamed layer and is fixed by a predetermined fixing means.

18. The antenna device according to claim 14, wherein
the antenna pattern is formed on a first-side surface of the foamed layer, and a second-side surface of the foamed layer is fixed to the inner surface of the case part.

19. The antenna device according to any one of claims 14 to 18, wherein
the antenna pattern is a mobile terminal configured to be able to carry out transmission/reception even during moving.

20. A manufacturing method of an antenna device having a case part, an antenna pattern fixed to an inner surface side of the case part, and a foamed layer having a foamed structure and disposed between the antenna pattern and the inner surface of the case part; the manufacturing method comprising:
a first step of injection-molding the case part by using a first resin to which metal does not easily adhere;
a second step of forming the foamed layer by using a second resin to which metal easily adheres; and
a third step of forming the antenna pattern on a predetermined antenna board.

21. The manufacturing method of the antenna device according to claim 20, wherein
a recessed part is formed at a predetermined position of the case part in the first step, and
the foamed layer is formed in an interior of the recessed part in the second step.

22. The manufacturing method of the antenna device according to claim 20 or 21, wherein
the first step and the second step are processed by two-color molding.

23. The manufacturing method of the antenna device according to any one of claims 20 to 22, wherein
the antenna board is the foamed layer.

24. The manufacturing method of the antenna device according to any one of claims 20 to 23, wherein
conductive paste is printed in the shape of the antenna pattern in the third step.

25. An antenna device comprising:
an antenna board formed of a foamed dielectric resin having heat resistance and a predetermined dielectric constant;
an antenna pattern formed on a first-side surface of the antenna board;
a feed board composed of a board material having rigidity with which cutting resistance that allows at least formation of a penetrating hole is obtained; and
a feed line formed on a first-side surface of the feed board; wherein
a second-side surface of the antenna board and a second-side surface of the feed board are joined by a predetermined joining means.

26. The antenna device according to claim 25, wherein
a joining layer is formed by using a tacky producer or an adhesive agent as the joining means.

27. The antenna device according to claim 26, further comprising
a metal pin having a first end soldered on the antenna pattern and a second end penetrating through the antenna board and electrically connected to the feed line.

28. The antenna device according to claim 27, wherein
the second end of the metal pin is further penetrating through the feed board and soldered on the feed line.

29. The antenna device according to claim 27, wherein
the metal pin is surface-mounted on the second-side surface of the feed board, and the second end of the metal pin is connected to a through hole electrically connected to the feed line.

30. The antenna device according to claim 25, wherein
the antenna pattern is connected to a first through hole penetrating through the antenna board, the feed line is connected to a second through hole penetrating through the feed board, and part between the second-side surface of the antenna board and the second-side surface of the feed board is soldered as the joining means, the part including electrical connection between the first through hole and the second through hole.

31. The antenna device according to any one of claims 25 to 30, wherein
the foamed dielectric resin is foamed PPS or foamed LCP.

32. The antenna device according to any one of claims 25 to 31, wherein
the foamed dielectric resin is MC-PPS (microcellular polyphenylene sulfide resin) having a specific inductive capacity of 2 or less and a foaming diameter of 10 µm or less in volume average.

33. A wireless communication device comprising, in a chassis: one or more antenna part, a high-frequency circuit part connected to the antenna part to carry out a predetermined communication process, and a circuit board having a first-side surface equipped with the high-frequency circuit part and a second surface on which a main ground plane is formed; wherein
each antenna radiation conductor part of the one or more antenna part is formed on a low-loss base material;
an antenna radiation conductor part of at least one of the antenna part and an input/output part of the high-frequency circuit are disposed to be away from each other by a predetermined distance or more;
a signal line is connected to the antenna radiation conductor part of the antenna part disposed to be away therefrom and formed of a conductor pattern on a first-side surface of the low-loss base material to a position of the input/output part;
a transmission line part that forms a microstrip line by disposing the signal line with an interval defined by the thickness of the low-loss base material from a ground pattern formed on a second-side surface of the low-loss base material is further provided; and
an end part of the signal line in a side opposite to the antenna radiation conductor part is connected to the input/output part by a predetermined elastic member, and two or more points on the ground pattern including vicinities of both end parts of the signal line are electrically connected to the main ground plane via another elastic member.

34. The wireless communication device according to claim 33, wherein
two or more said antenna parts are provided to carry out MIMO (Multiple-Input Multiple-Output) operation in at least one receiving band.

35. The wireless communication device according to claim 33 or 34, wherein
the antenna radiation conductor part is formed on one surface or both surfaces of the low-loss base material excluding a region in which the ground pattern is formed.

36. The wireless communication device according to any one of claims 33 to 35, wherein
the antenna radiation conductor part of the antenna part and the input/output part disposed to be away from each other are away from each other by 50 mm or more.

37. The wireless communication device according to any one of claims 33 to 36, wherein
the thickness of the low-loss base material is 0. 2 mm or more.

38. The wireless communication device according to any one of claims 33 to 37, wherein
the low-loss base material has flexibility and can be housed by being deformed along the shape of the chassis.

39. The wireless communication device according to any one of claims 33 to 38, wherein
the low-loss base material is a resin foam containing independent bubbles in its interior.

40. The wireless communication device according to claim 39, wherein
the resin foam has a foaming diameter of the independent bubbles of 20 µm or less.

41. The wireless communication device according to any one of claims 33 to 40, wherein
the low-loss base material and the ground pattern of the transmission line part have a width of 8 mm or less, and the transmission line part is bent at about 90 degrees with respect to the antenna radiation conductor part and disposed along a wall surface of the chassis.

42. The wireless communication device according to claim 41, wherein
the transmission line part is disposed so that the ground pattern is directed toward the wall surface side of the chassis.

43. The wireless communication device according to any one of claims 33 to 40, wherein
the circuit board is equipped with two or more circuit blocks and has a metal frame for electromagnetically separating the circuit blocks;
the low-loss base material and the ground pattern forming the transmission line part have a width equivalent to that of the circuit board; and
the ground pattern is pushed against and placed on the metal frame.

44. The wireless communication device according to claim 43, wherein
the ground pattern has a thickness of 100 µm or more.

45. The wireless communication device according to claim 43 or 44, wherein
on the surface of the low-loss base material on which the signal line is formed, a thermal diffusing pattern connected to the ground pattern via a through hole is formed to be away from the signal line by 200 µm or more.
